(19) **Europäisches Patentamt / European Patent Office / Office européen des brevets**

(11) **EP 3 007 228 B1**

(12) **EUROPEAN PATENT SPECIFICATION**

(45) Date of publication and mention
of the grant of the patent:
**17.03.2021  Bulletin 2021/11**

(21) Application number: **13885219.9**

(22) Date of filing: **07.12.2013**

(51) Int Cl.:
**H01L 27/146** *(2006.01)*   **G02B 13/00** *(2006.01)*
**H04N 5/225** *(2006.01)*   **H01L 31/0232** *(2014.01)*
**H04N 9/04** *(2006.01)*

(86) International application number:
**PCT/ES2013/070855**

(87) International publication number:
**WO 2014/188018 (27.11.2014 Gazette 2014/48)**

(54) **MONOLITHIC INTEGRATION OF PLENOPTIC LENSES ON PHOTOSENSOR SUBSTRATES**

MONOLITHISCHE INTEGRATION VON PLENOPTISCHEN LINSEN AUF
FOTOSENSORSUBSTRATEN

INTÉGRATION MONOLITHIQUE DE LENTILLES PLÉNOPTIQUES SUR DES SUBSTRATS
PHOTODÉTECTEURS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **21.05.2013  ES 201330727**

(43) Date of publication of application:
**13.04.2016  Bulletin 2016/15**

(60) Divisional application:
**21155638.6**

(73) Proprietor: **Photonic Sensors & Algorithms, S.L.
46980 Paterna, Valencia (ES)**

(72) Inventor: **BLASCO CLARET, Jorge Vicente
E-46020 Valencia (ES)**

(74) Representative: **Clarke Modet & Co.
C/ Suero de Quiñones 34-36
28002 Madrid (ES)**

(56) References cited:
**WO-A2-2008/020899    US-A1- 2009 102 956
US-A1- 2010 277 627    US-A1- 2012 012 959
US-A1- 2013 033 636    US-A1- 2013 321 581**

## Description

## 1. Technical Field

The invention disclosed herein is related to image capture, more specifically with capturing plenoptic images with a solid-state sensor, where not only is the image captured, but also the direction of arrival of the light rays. This field comprises optical elements, optoelectronic sensors (that convert light intensity into electrical current) and processing elements of the images captured. It is aimed at reducing costs of production of image sensors while increasing its quality, reducing its size and offering manufacturing capacity with very high volumes. The invention provides optical designs at wafer level and the creation of "sandwiches" of several optoelectronic and optical wafers, resulting in sensors that can be used in digital cameras, mobile phones, tablets, laptops and general consumer goods that incorporate cameras, especially but not exclusively in combination with CMOS image sensors. Various structures of the image sensor and methods of manufacturing are described herein.

## 2. Prior art.

It is usual to refer to "Monolithic integrated circuits" to those obtained using common chip design techniques, in which the base material (substrate) contains not only the active elements (transistors, sensors, etc.) but also the elements of interconnection. The use of this term refers to the integration of technologies and functions which are usually different, for example the use of analog and digital circuits on the same chip, or the integration of power semiconductors with analog, digital circuits, signal processing, sensors and protection circuits on the same chip.

In optoelectronics, "monolithic integration" refers to the tendency to integrate into a single "electro-optical integrated circuit" features such as input/output optical fibers, optical waveguide cavities on-the chip itself, usually made of "electronic materials", lasers, detectors, and all with their bias, control and system management electronic circuits.

In a normal camera, the film (or the sensor in a digital camera) captures a two-dimensional image where each point of the film (or pixel sensor in a digital camera) integrates all the rays of light that reach a point from any direction. A plenoptic camera (or light field camera) is able to sample a range of light and also the direction of the rays of light in a light field.

The capture of the direction of arrival of light allows synthesizing "new views" or new images such as 3-dimensional images, images re-focused at different distances and "completely focused" images (regardless of the distance of the objects in the real world).

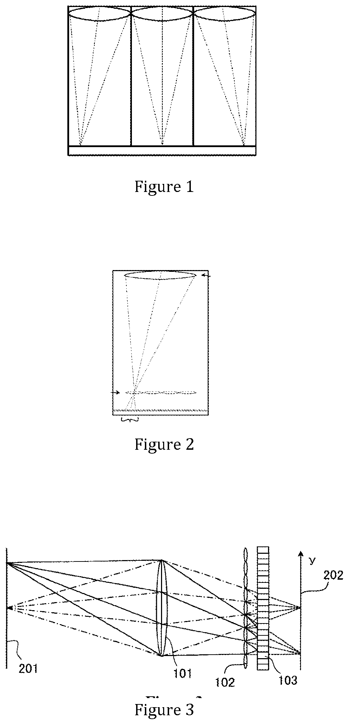

Figure 1 (reproduced from U.S. Patent 8,290,358 B1; inventor Todor G. Georgiev) illustrates an implementation of prior art, an array of cameras (with two or more lenses or objectives, in the case of the figure three lenses on the top portion of the figure). Each lens/objective focuses images of the real world in a particular part of the photo-sensor (thin film on the bottom of the image), although it would also be possible to do so in several photo-sensors. The number of captured images can be combined to form a single image.

Figure 2 (again reproduced from US patent 8,290,358 B1) illustrates a second implementation of prior art of a plenoptic camera, that uses a single objective or lens (at the top of the image) and a set of microlenses (or array of microlenses) which can for example include 100,000 lenslets (or many more in recent implementations) located one next to the other forming a two-dimensional pattern (the array of microlenses, marked with an arrow in Figure 2, is located in this figure at the point where the three beams cross). Said array of microlenses is typically located at a small distance (about half a millimeter) of a photo-sensor (bottom part of the image) which may be a CMOS (Complementary Metal Oxide Semiconductor) sensor, CCD (Charge Coupled Device) sensor or any other past, present or future photo-sensor technology. The plane of the array of microlenses is parallel to the plane of the photo-sensor Document US 2013/0033636 discloses an imaging device comprising a monolithically integrated plenoptic microlenses array.

The image captured by the plenoptic camera sensors described in previous paragraph is actually a collection (array) of small images of the main lens / objective of the camera, these images are often called "micro-images." The structure "micro lens / sensor" described allows to capture at each point not only the light brightness but also the distribution of light intensity arriving from different directions. Each of the several microlenses separates the beam from the main lens coming to it as rays from different positions of the main lens. Light rays are stored as pixels in the photo-sensor, and the set of pixels below each micro-lens forms an image of n-pixels called macro-pixel (marked with a bracket in Figure 2).

A third type of "light field camera" is similar to that of Figure 2, except that the microlens array is replaced by an array of apertures (small holes on an opaque surface that allow light passing through). A fourth type of "plenoptic cameras" is similar to that of Figure 2 except that a no refractive "sinusoidal-mask" replaces the microlenses, said mask modulates the incident light but does not refract it, resulting in a captured image which is the convolution of the light field incident with the light field mask; this camera captures the light field directly in the frequency domain (the Fourier domain). Thus, a two-dimensional (2D) sensor with pixels represents an encoded linear combination of several incidents rays, said linear combination can be decoded by software to obtain all of the information of the light field (including the direction of arrival of the rays).

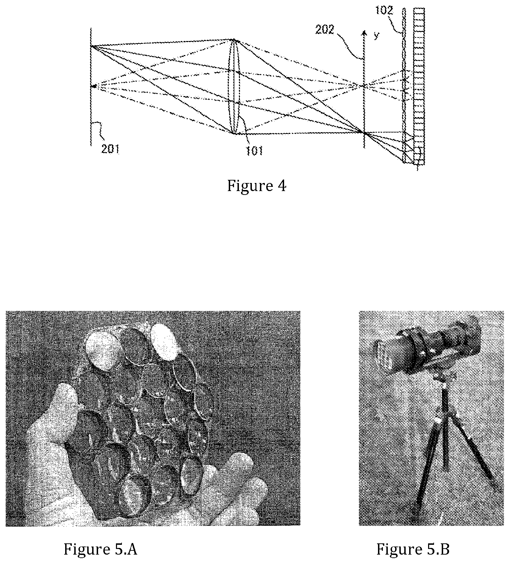

Figures 3 and 4 (reproduced from GB 2,488,905, inventors Norihito Hiasa and Koshi Hatakeyama) illustrate the propagation of the light rays and the fundamentals of algorithms that can be used for various tasks such as refocusing, calculation of distances to the camera, etc. Figure 3 illustrates the case where two points of the target plane 201 come to focus in a plane 202 which is positioned beyond the plane of the microlenses, however, these rays never reach focus, they are diffracted by the microlenses and give rise to several pixels in the sensor (instead of a single pixel in the plane that would have been focused). Figure 4 illustrates the case in which two points in the object plane 201 come to focus on an earlier plane 202 than the microlenses 202 and from that point diverge, the rays are diffracted by the microlenses and reach several pixels at the sensor plane 103. In both cases, if the sensor (or film) were at the place where the microlenses 102 are, the image of these points would appear blurred; however, with a plenoptic camera, where you can determine the direction of arrival of the rays, there are multiple algorithms to calculate what would be the focused image of the two pixels described in Figures 3 and 4, calculating the "backtracing" of the light rays (from the sensor 103 in the image space at the right of the main lens 101 up to the focal plane 202, and even it is possible to trace back to the origin of these rays in the object space, over the plane 201 at the left of the lens 101). Due to similarity of triangles in the image space and in the object space, it is also possible to calculate the distance from the focal plane (201) to the planes described in Figures 3 and 4 (101, 102 and 202), it is even possible to calculate the distance between pixels of an image to the origin of these pixels in the object space, with this information it is then possible to create images for 3-dimensional (3D) televisions, refocusing images, produce images completely focused, etc.

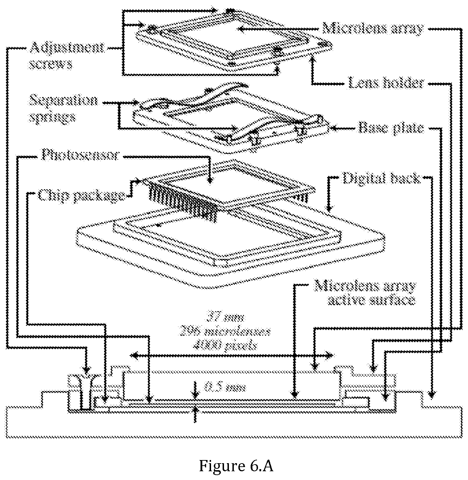

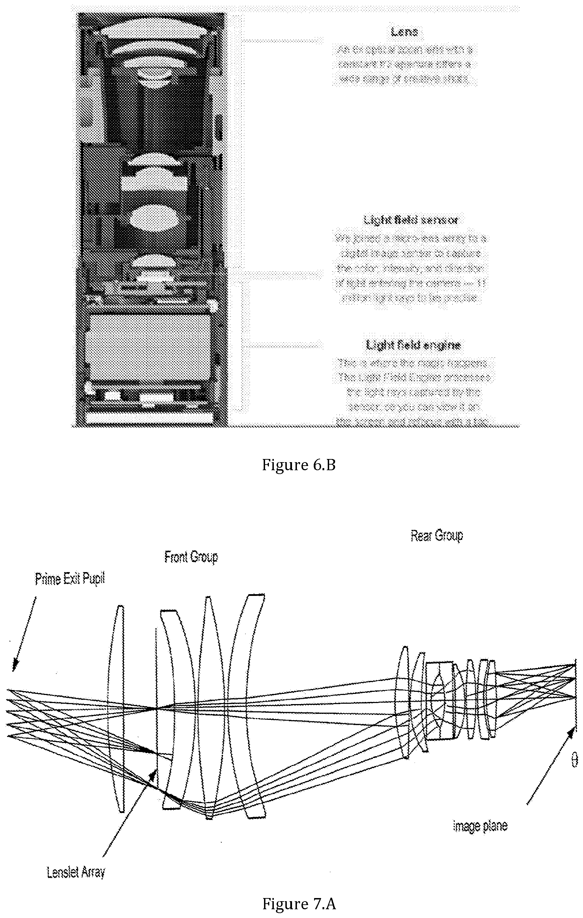

Although we have described the plenoptic camera with later implementations, it was already described in 1908 by Lippman, but technological difficulties did not allow significant progress until 2004, when Ng, Hanrahan, Levoy and Horowitz in their patent US 2007/025074 (and as in the "Stanford Tech Report" CTSR 2005-02) described a camera whose resolution was the same as the number of microlenses used. In October 2004 Ng, Hanrahan, Levoy and Horowitz (U.S. 2012/0300097) describe a plenoptic sensor with a structure similar to that described in Figures 2, 3 and 4. We reproduce said sensor in Figure 6.A, discussing below their main parts. The lower part of the image describes the whole assembly, while the upper part of the image describes the various parts of said assembly. The "Digital back" provides mechanical strength to the set, while carrying out the functions of the printed circuit board where the "Chip package" (with their respective chip input-output pins that plug into the "Digital back") is plugged in, the chip includes a "Photosensor", the structure also includes a "Base Plate" mounted over the Photosensor, as well as a "Microlens array" (or array of microlenses) mechanically fixed to a "Lens holder", said Lens holder is attached to the "Baseplate" (base) with three "Separation springs" maintaining a certain distance between the microlenses and the photo-sensor, " Adjustment screws "(or screws) located in three positions control the distance and parallelism of the planes of photo-sensors and micro-lens array. This figure does not show the main camera lens.

The ideas described in the patents above gave birth to the early plenoptic cameras oriented to the consumer market, in 2012 the company Lytro began marketing the camera whose scheme is shown in Figure 6.B, the company whose workforce included one of the inventors of the aforementioned patents. The figure 6.B (extracted from www.lytro.com) shows on its top part a set of input lenses (zoom of 8x and fixed aperture f/2), a "light field sensor" with similar concepts to those of Figure 6.A (with a "microlens array" and a "digital image sensor"), and at the bottom of the image the "Light field engine" (consisting of some processing capacity to implement plenoptic algorithms briefly mentioned in the previous paragraphs (fundamentally re-focusing on early versions of the product)).

In 2008 Lumsdaine, Georgiev and Intwala described a design with a higher specification in terms of effective resolution than in the aforementioned patents (until then only one pixel per microlens) ("A. Lumsdaine and T.Georgiev. Full resolution Lightfield rendering. Technical report, Adobe Systems, January 2008 ", and the patent US 2009/0041448).

In October 2009 Georgiev described (U.S. 2010/0020187) a different variant in which in a conventional camera (with its main lens located in front of the sensor) several lenses and several prisms are added (the set of lenses/prisms obtains different views of the same image and directs said views towards the sensors through the main lens). This patent provides pictures of the set of lenses/prisms (attached as Figure 5.A) and the set "lenses/prism/main lens" assembly mounted in a camera (Figure 5.B). The images obtained through the various input lenses are combined to sample the "light field".

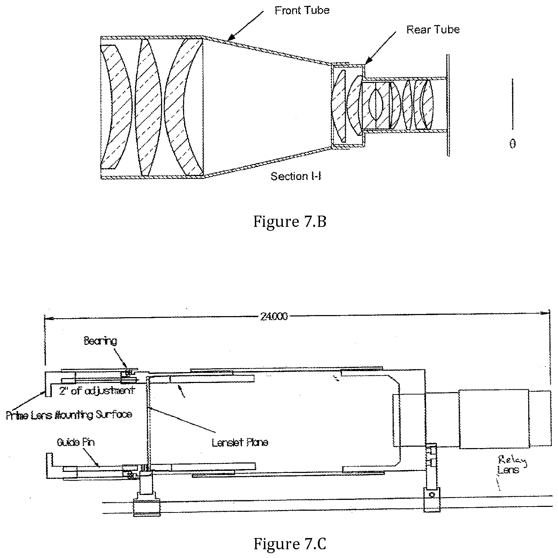

With priority date in October 2009, DiFrancesco Selkirk, Duff, VandeWettering and Flowers, in the patent US 2011/0169994, describe slightly different optics (see Figure 7A) in which the "Microlens array" ("Lenslet Array") stands at the front of a lens system, but with an input lens between said lens array and the object space. The practical implementation of said lens system (Figure 7B) is described with a "Front tube" containing lenses with larger diameters and a "rear tube" with lenses of smaller diameter in the right side of the image, nearer to the connection of said optics to the camera. The array of microlenses and the input lens are added to said structure to the introduction of a third tube (as described in figure 7.C). The principles and algorithms used in the structure are similar to those used in the structures described above: "obtaining a sample of the light field from multiple images".

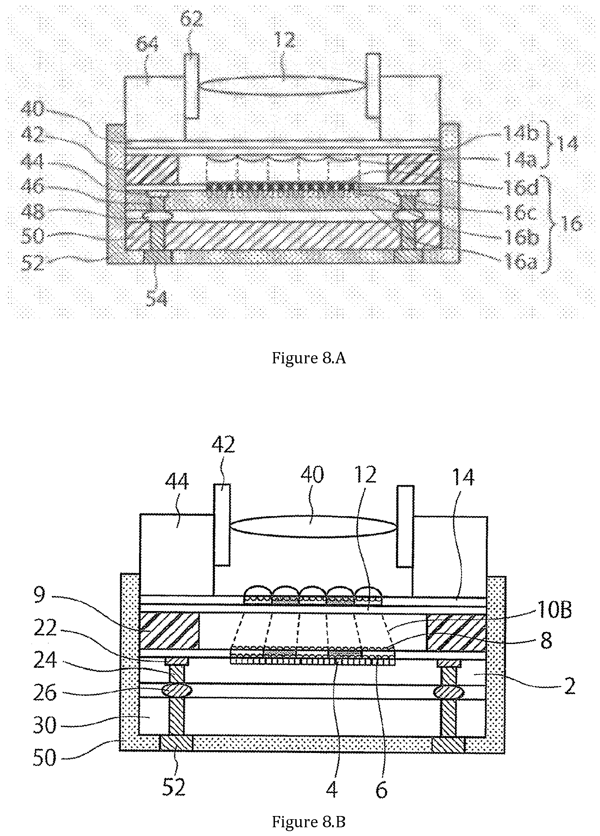

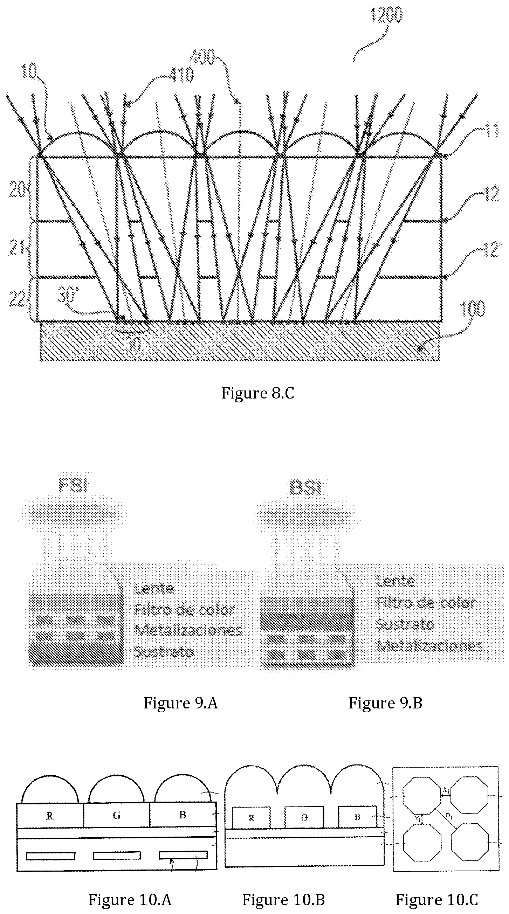

Irrelevant of the possible positioning the above-mentioned implementations seem to target, from prototypes to market-oriented consumer products, including prototypes that pursue very high optical quality for sophisticated applications, there was a simultaneous trend towards reduction of volume and manufacturing costs. In February 2001 Ueno, Funaki and Kobayashi (US Patent 2012/0218448) describe an "imaging device implemented in solid state", a small camera module (see Figure 8. A), including an input lens 12 which sends the light to a "microlens array" 14 (including a transparent substrate 14b and the microlenses themselves 14a), light is eventually sent to an "image capture element" 16 containing pixels 16b, such as photo-diodes, which convert light energy into electrical energy, said element is formed by a semiconductor substrate 16a, bias and reading circuits (not shown in the Figure) that provide electric power and read the pixels 16b formed in the substrate 16a, color filters 16c (e.g. red, green or blue) corresponding to each pixel 16b, arranged in standard formats such as the Bayer format, and finally a small micro-lens 16d optional on each color filter, whose task is concentrating the light beam incident on each of the photo-sensors (pixels 16b). At the top of the assembly "semiconductor substrate/colored filters/pixel micro-lenses" (16a-b-c-d), but outside the area of the photo-sensors, there are "resin spacers" 42, which aim to maintain the distance between the photosensors 16 and the microlenses 14, they are part of an assembly that includes a "light transparent substrate" 40, which may be made of material that lets visible light pass but eliminates infra-red or near infra-red light; in the semiconductor substrate there are "reading and bias electrodes" 44 for the pixels 16b, such electrodes are connected by metal columns 46 which cross vertically the semiconductor substrate 50 by means of the "contact points" 48; the chip 50 may contain the bias circuits and processing of the photo-sensors (pixels). The input lens 12 is placed in a fix position by means of a cylinder 62, which is held in position by a support 64 placed on the transparent substrate 40; a "protective frame against external light" 52 is externally mounted over said structure as an outer cover of the entire assembly, to prevent entry of light from the substrate 16A or the chip 50, said cover is only interrupted by the electrodes 54, which electrically connect said structure to the outside electronic system. This patent (namely the "Claim" 1) claims a solid-state imaging system comprising: a semiconductor sensor comprising blocks of pixels and these by pixels; a first optical system (represented in the figure by the lens 12); a second optical system (represented in the figure by the microlenses 14) and establishes that the imaging plane of the first optical system (lens 12) when the object is located at infinite distance should be within a distance of the first optical system (lens 12) greater than the distance between the first optical system (lens 12) and the image sensor (16).

In March 2011, Ueno, Iida and Funaki, in their patent US 2012/0050589 (see figure 8.B reproduced from said patent) reveal slightly different structures to those described in the previous paragraph, for example, with the microlenses facing the input lens system (instead of facing the sensor) and/or adding color filters (e.g. red, green and blue) in the micro-lens and in the sensor, forming certain patterns, such as the Bayer pattern) so that their image sensors also capture the colors, and describing methods for making such structures where color filters (and their associated sensors) are diverted towards the periphery of the imaging area (see Figure 8.B), with major diverting deviations as they get the closer to the periphery.

Progress in manufacturing processes for monolithic sensors, micro-electronics and optics as part of a single dice was also shown in October 2009 by Brueckner, Duparre, Wippermann, Dannberg and Brauer in their patent US 2011/0228142 A1, one of its embodiments is reproduced in Figure 8.C., it is not a plenoptic structure, it only allocates microlenses 10 to groups of photo-sensors 30' contained in a substrate 100, creating " 3D space observation cones " (observed in the lines 410), said cones truncated at their narrowest parts (located on the microlenses) and widening with the distance, with some overlap in their fields of vision in the object space. To avoid noise from optical coupling between the different optical channels (crosstalk) associated with each microlens 10 there are opaque layers 11, 12 and 12' with openings to just let a suitable beam of light through. The transparent substrates 20, 21 and 22 are constructed of glass, plastic or inorganic copolymers (e.g. ORMOCER). The focal length of microlenses coincide with the distances between the microlenses 10 and the sensors 30', these focal distances have typical values between 30 and 3000 microns, with diameters of micro-lenses between 10 and 1000 microns, a number of microlenses between 4 and 25,000 and a number of pixels between 10,000 and 10 Mega pixels or higher. The sensors 30' create several micro-images (between 4 and 25,000) that are subsequently combined by additional hardware or software. The main advantage of this structure is its low volume, since no additional lens is required, a design optimized for portable applications, and it lends itself to high-volume manufacturing processes.

The history of the light field cameras has been a parallel evolution of three fields, optics (as explained above), algorithms (which, starting from the pixels of the photo-sensors create images with new features: images with different focus, images totally focused, 3D images, etc.) and microelectronics/micro-optics, producing photo-sensors with evolving performances (in terms of number of megapixels, luminosity, contrast, etc.). The initiatives described in the preceding two paragraphs were among the first where the processing and manufacturing of the optical elements used similar techniques as those used in microelectronics, leading to manufacturing techniques at wafer level that drastically reduce the costs, while providing high quality levels and very high reproducibility. However, the formation of microlenses and color filters on the semiconductor photodiode panels has been used in recent decades with a similar structure as that of Figure 10.A (reproduced from patent US 2012/0012959 A1; inventor Po-Shuo Chen), showing a typical representative sensor of prior art in CMOS (Complementary Metal Oxide Semiconductor) technology: from bottom-up we can distinguish a semiconductor substrate where in the interior there are three photo-sensors , the semiconductor is protected by a thin layer of silicon nitride, on said substrate color filters R (Red), G (Green) and B (Blue) are placed, but another basic color system like cyan, yellow and magenta could be used; finally on top there are three micro-lenses, built with optical materials that concentrate the light towards the photo-sensors, increasing the luminous efficiency of the structure (usually in most publications on optics the sensor is represented by a simple flat photosensitive plane, like a traditional film with a continuous photo-sensitive layer in which the photosensitive elements have infinitely small dimensions, but in reality the pixels of each photo-sensor have a discrete size and there are spaces between individual photosensors to separate them and hold bias and reading circuits, hence the usefulness of the microlenses mentioned above). Color filters are typically fabricated by photolithographic methods, in which each photosensitive color layer is deposited, partially exposed to light (with a pattern of negative shading photolithographic masks) and etched (developed), but also it can be formed by jet printing. The microlenses (usually made with thermoplastic resins or photo-resistive transparent material) are often formed by depositing such materials followed by photolithography and heating process, hardening by heat reflux, and curing.

In July 2010, Po-Shuo Chen described a structure with better features in the patent US 2012/0012959 (Figure 10.B) where color filters are separated between them and the array of microlenses presents no gaps between adjacent microlenses, a top view (Figure 10.C) shows the polygonal structure of said color filters (with gaps between them in the horizontal and vertical directions (X1, Y1) lower than the diagonal direction (D1). The benefits of such structure to avoid "crosstalk" (crosstalk between colors) are evident, besides this structure avoids the gaps between microlenses and thus increases the light efficiency. Chen also explained that this structure (with gaps between color filters) opens the possibility of a new manufacturing method for microlenses based on deposition and thermal processing, whereby it opens the flexibility of using transparent materials that are not photo-resistive, such as thermo-plastic resins. Obviously, a photolithographic processing of each micro-lens will allow higher precision than with the material processed by deposition and subsequent heat treatment, however the process adds flexibility in the choice of materials.

Another notable progress has been in more light-efficient sensors, evolving from a FSI (Front Side Illumination) technology to BSI (Back Side Illumination) technology, the difference between the two is illustrated in Figure 9: in a standard CMOS process (Figure 9 A, FSI) the silicon process is carried out to create photo-sensors and the area between different photo-sensors as well as the area over the photosensors needs to be used for the metal layers that carry different electrical signals (bias and photo-sensors reading, power supply voltages, etc.), these metallization layers provide opaque structures which deteriorate the luminous efficiency of the sensor; the solution to this problem is immediate, interconnections and metallization are performed on the opposite side of the substrate where the photo-sensors have been created (Figure 9.b) thus eliminating the opaque layers between the photo-sensor and the color filter, thereby improving luminous efficiency. Anecdotally it is worth mentioning that in the promotional materials of Apple iPADs they reveal that their cameras have among other features rear lighting or BSI. Other advantages provided by the BSI technology are that they make possible optical modules of smaller dimensions, allowing also wider openings (faster lenses) and allowing designing zooms of highest quality.

Up to now we have described the first plenoptic initiatives undertaken with large size discrete optics, the first initiatives that place an array of micro-lenses at very small distance from CMOS or CCD sensors, other initiatives that place the microlenses as an add-on module added to the external objectives of the camera, and finally the first step towards a monolithic integration and wafer processing, where the microlenses are placed on a transparent substrate resting over resin spacers over the substrate in which the sensors are manufactured, for example CCD sensors or photo-sensors in a CMOS manufacturing process on a semiconductor substrate.

One of the main improvements of the invention set forth herein is that we go a step further towards monolithic integration, leading to structures processed on a single wafer, instead of optical and electronic structures processed in different wafers and afterwards coupled by spacers, leading to better optical characteristics and production methods of lower cost and higher quality.

We also made a brief review of the state of the art of photo-sensors, especially sensors in CMOS technology, with more and more megapixels, evolving into BSI (Back Side Illumination) structures, with color increasingly sophisticated, as well as structures that position very precisely a micro-lens above each photo-sensor in order to to concentrate the light in the active area, avoiding wasting incident energy on the semiconductor area without photosensitive surfaces, the area which contains only bias or reading circuits.

Finally, before moving to the description of the invention, we summarize the several trends to mount the complete assembly containing the optics and their respective sensors. First, a plenoptic sensor installed in a commercial camera (present or future) which could have nearly normal lenses as described in Figure 7B (with more or with less sophistication, with fixed objectives or with zooms), the only difference from a current camera (besides the micro-lenses of the plenoptic sensor) is the post-processing of the recorded pixels on the sensor. Second, cameras commercially available today (and future cameras) may have micro-lenses mounted on an external objective as described in Figure 7.C (or similar). These trends provide a high definition camera in terms of number of megapixels (because it is relatively simple to manufacture many megapixels on a sensor whose horizontal and vertical dimensions are several square centimeters) and high optical quality thanks to the large lenses, which will ensure low optical aberrations and high luminous efficiency. This segment will cover the niche market of medium, high and very high prices, arriving at the end to professional solutions of high quality for TV and cinema.

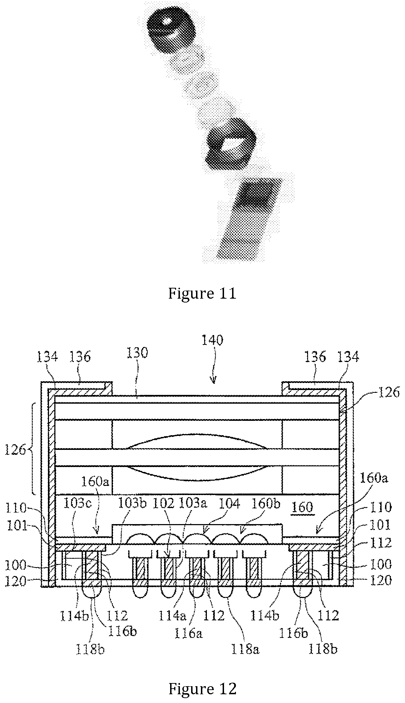

An intermediate trade-off in terms of quality and cost is exemplified in Figure 11 where it can be seen at the bottom a "flexible circuit" on which a photo-sensor chip is mounted (similar to those described above, but in this figure additional encapsulation for connection to external electronics and a small transparent glass on top of the chip sensor are included, glass which aims to let in light while preventing the penetration of dirt, dust and moisture in the area of photo-sensors). This chip is housed in a mechanical structure that aligns the sensor with several lenses, resulting in a module, which aims to be housed in mobile phones, laptops and other small consumer devices. The typical price of these modules is very low, as they are designed to be part of consumer goods that are produced by millions (mobile computers and smartphones) whose price should be affordable to a large number of people.

The structure described above, despite its relative low cost, implies a non-negligible mechanical and assembly complexity, even if thanks to the use of robotic or automated assembly techniques the price of a large number of lenses using the mechanical structure described is low, still is relatively high compared to similar structures that can be assembled using processing techniques similar to those employed in microelectronics or micro-optics. Following this trend, in November 2007, Weng and Lin described (in patent US 2009/0134483 A1) a compact camera module, reproduced in Figure 12, comprising a photo-sensor chip (102), a set of lenses (126) and an outer shell with electrically conductive material (134). The module includes a substrate 100 which may be of silicon or another semiconductor material, and may contain a CCD or a CMOS image sensor, a transparent substrate 160 located on the semiconductor substrate 100 and an array of microlenses 104 located between the two structures, the CCD or CMOS sensor contains an array of opto-electronic components 102 such as photodiodes or phototransistors, built in the substrate 100 by typical semiconductor techniques. At least one ground pin (I/O pin) 114b is connected to the semiconductor substrate 100 and the conductive layer 101 formed on the substrate using microelectronic fabrication techniques. Also, a set of pins 114a is positioned to take outside the readings of photo-sensors. Both, the ground pins as as well as the pins of the photo-sensors are isolated electrically from the substrate by a dielectric layer 112. On the semiconductor substrate 100 a transparent substrate 160 (glass or quartz) is mounted, forming a cavity 160b over the sensors 102 and their respective microlenses 104. On the transparent substrate 160 a set of lenses 126 is placed, then a conductive layer is thereafter positioned on the semiconductor substrate 134 and the lens, whose function is to protect all sensory structure against interference from electromagnetic noises, since this layer is grounded through the layer 101 and the pin 114b. Further, an opaque layer 136 can be used (which may be as simple as a simple opaque paint) on the conductive layer 134 in order to obtain a better luminous insulation structure. To increase the immunity of the structure to external electromagnetic radiation a transparent conductive layer 130 can be used on top of the structure formed by materials such as IZO (Indium Zinc Oxide) or ITO (Indium Tin Oxide). This patent also describes a manufacturing method based on wafer processing, allowing production of large quantities of camera modules at very low prices, for example they not only use such techniques to manufacture the sensors, but also to place glass wafers or quartz wafers 160 on the semiconductor substrate wafer 100, or to position lenses 126 on the glass or quartz wafer substrate 160, or to deposit a transparent conductive layer 130 wafer over all sub-modules built in the wafers below. Finally, this structure passes to a cutting process (dicing), or separation of each of the sub-modules built on a wafer, then the usual techniques of microelectronics packaging are used, such as BGA (Ball Grid Arrays) or "solder balls" at the bottom of the chip, normally available in modern packaging for high density chips (represented in the figure with numbers 118b and 118a), allowing a very high and dense number of input-output pins, very convenient to quickly dump outside an increasing number of mega-pixels with new CMOS technology more commonly used in high-density sensors.

T.Y. Lin, C.Y. Cheng and H.Y. Lin described in May 2007 novel modules in their patent US2011/292271 A1 (reproduced in Figure 13), the bottom of the figure includes solder balls to connect the module to a printed circuit module, the structure includes photo-sensor modules 300 (CMOS or CCD) on which is deposited an array of micro-lenses 302 similar to those described above, whose purpose is to concentrate light on the active area of each photo-sensor, on said structure a transparent substrate of materials such as glass, quartz or other transparent material has been placed. This structure is similar to that of any other CCD or CMOS sensor, but from here a planar structure 112 is placed, consisting of a dry photo-resistive film (dotted area), very similar to that commonly used in micro-electronic processes but with characteristics of high adhesiveness, said layer, whose thickness can be controlled at will depending on the distances designed between the sensor and the lens, the structure is processed and attacked through a photolithographic process, leading to a structure with an empty space (112a) between the transparent substrate and the lenses 10; lens (10) is formed by a substrate 100 and two elements 102 and 104 in the two opposite surfaces of the substrate 100 (which in the image are convex but could be concave) lenses are made of organic materials such as glass, epoxy, acrylates or silicone; the mechanical bond between the different layers is performed with heating processes. More lenses can be added to said structure by depositing new layers of photoresistive material (206 and 214) and their selective etching to form gaps of spacing between the lenses (206a and 214a), finally placing a transparent substrate 216 at the top of the structure. The manufacturing process described lends itself to wafer processing, with the first wafer containing the photo-sensor, on which the pixel microlenses 302 are located, and from that structure several lenses are built, one after another on all sensors of the wafer, finally proceeding to the cutting process (dicing or obtaining a dice) from which a large number of camera modules are derived.

The process described in previous paragraph reduces dramatically manufacturing costs and is especially useful when compared with the alternative of using glass spacers between the lenses or between the sensor and the first lens, especially considering that for technological reasons glass separators cannot reach thicknesses below 300 microns (by the present invention thicknesses up to about 30 microns are achieved, giving more flexibility to the designer of lenses, by reducing the thickness of the assembly and avoiding the use of adhesive materials for the structure.

CCD sensors are used and have been used in digital cameras and in many applications, however, the CMOS sensors have increased in popularity because of their cheaper production costs, higher yields in their manufacturing processes (percentage of parts fulfilling specifications) and smaller sizes, all thanks to the use of technology and equipment developed for semiconductor manufacturing equipment (same technology and equipment as used to manufacture microprocessors, memories and logic circuits).

In parallel to the cited progress, and in principle in a different field meta-materials have evolved, such materials include small-scale structures designed for handling electromagnetic waves, and already in 1967 Victor Veselago theorized about the possibility of materials with negative index of refraction in his article "The electrodynamics of substances Simultaneously With negative Values of ε and μ" [1]. In 2007 Henry Lezec obtained a negative refraction in visible light [2] and since then various groups have theorized about the possibility of the use of these materials for applications such as invisibility or microscopes with magnifying power far beyond the state of the art.

## 3. Detailed Description

The following description reflects particular ways of implementing the invention but its main purpose is to illustrate the principles of the invention and should not be taken in a limiting sense. The scope of the invention is best determined by reference to the claims of this document.

In addition to the definitions of monolithic integrated circuits described in the prior art, the term monolithic extends in the present invention to electro-optical sensors incorporating into a single structure also the several layers of optical materials located over the sensor substrate, which optically process light rays before arrival to the sensors. Said monolithic structure is mainly processed by methods commonly used in microelectronics and/or micro-optics not only for the photo-sensors (typically CCD or CMOS sensors or any other sensor built on a substrate, typically a semiconductor substrate) but also for the upper optical layers.

The main novelty of this invention as defined in claim 1 is the use of optical layers of different refractive indices positioned one on top of the other, including plenoptic microlenses, the bottom most of said layers over a photo-sensors substrate (CCD, CMOS or other past, present or future photo-sensors technology).

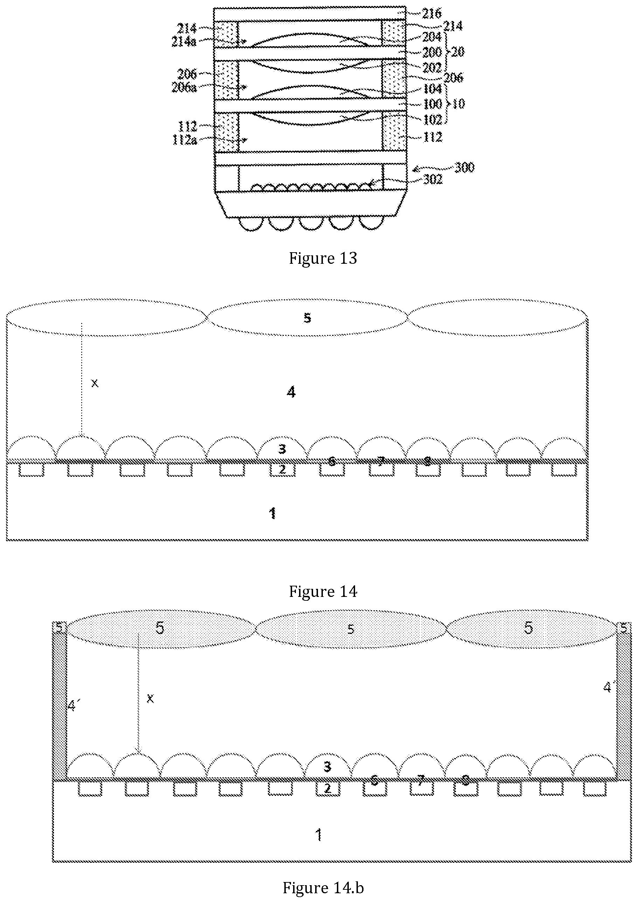

Referring to Figure 14, we can distinguish, from bottom to top, a substrate 1 on which the photo-sensors 2 are located (the substrate may for example be a semiconductor substrate, the photo-sensors may for example be photodiodes, phototransistors or other photo-sensors, semiconductor technology used may be a CMOS technology or any past, present or future technology to manufacture photo-sensors and/or electronic circuits); the figure shows only one dimension, but the sensors are constructed in two dimensions, forming a "two-dimensional array". On the "array of photo-sensors" color filters (6, 7 and 8) can be placed if desired to build a color image sensor (compared to one in white, black and shades of gray), color filters usually contain the three primary colors (green 6, red 7 and blue 8; or yellow, magenta and cyan if other set of primary colors is used), the array of color filters has evolved from a structure like that of Figure 10.A to a structure as that of Figures 10.B and 10.C; in the most modern manufacturing processes a micro-lens is placed over the color filters for each photo-sensor/filter, the aim of these micro-lens is to focus the beam of light into the inner part of the pixel (on the active area of photosensor), since the addition of all areas of all sensors 2 is less than the area of the substrate 1 due to the need to use part of the space for biasing and reading circuits; on the microlenses 3 an optical layer of low refractive index 4 is built, so that the light beams are refracted toward the photo-sensors concentrating all the light energy per unit area through the area 4 in the area of the photo-sensors 2; in order to meet this condition met the refractive index of material 4 must have a value below the refractive index of the material 3; finally, the microlenses 5 (with a material of high refractive index, higher than the material 4) are placed.

The structure formed by the materials 5, 4 and 3, by properly designing the profiles of the lenses 5 and 3 and the distance x, we obtain a similar plenoptic structure as described in Figures 2, 3, 4, 6.A, 6.B, 8.A and 8.B (in the implementation of Figure 14, under each plenoptic microlensing 5 there are 4 pixels, actually they are 16 pixels in the two-dimensional structure assuming the plenoptic lenses 5 have a square shape (with 4x4 pixels), although as we will see later it is possible to design the geometry of the pixels and microlenses following different patterns than the traditional); the structure described is in several ways better than the structures descried above from the optical point of view: as compared to structures with the micro-lens near the image sensors, similar to Figures 3, 4, 6.A and 6.B, the mechanical complexity and manufacturing costs are reduced drastically, it also becomes possible to use a plenoptic sensor as recited with traditional or near-traditional lens-objectives for professional cameras with high quality optics and a very high number of pixels. Designing a sensor of this type for a large camera to produce a large number of pixels in an area of a few square centimeters with an area of each micro-lens of relatively high values is relatively easy, as compared with the difficulty of designing a camera for a mobile telephone or a laptop, where the number of megapixels desired and the number of microlenses desired must be fitted to very small sizes (less than 1 cm x 1 cm), for those cases our sensors offer better characteristics than the solutions in Figures 5.A, 5.B, 7.A and 7.C. Besides our invention offers the possibility of a better control of the tolerances of microlenses in a microelectronic process (photolithography or otherwise) as compared to a discrete manufacturing as carried out in the Figures 5.A, 6.A, 6.B, 7.A and 7.C. The mechanical and manufacturing complexity is also lower than achievable in Figures 8.A and 8.B avoiding alignment processes between different wafers and air gaps (or other gas) as those gaps between the microlenses and the sensors of said figures, structures inherently less monolithic than the structures described in the present invention, structures are more amenable to the presence of contaminating materials between the sensor and the microlenses.

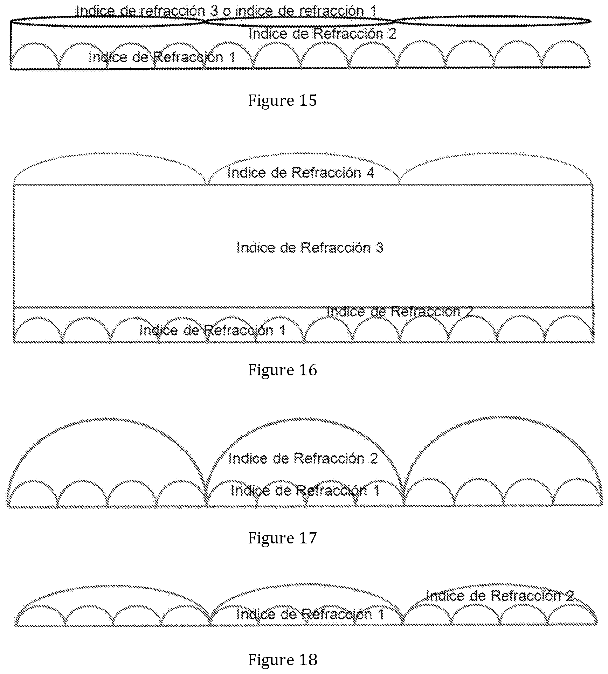

Returning to Figure 14, the microelectronic manufacturing processes not only allow extremely high precisions for designing the microlenses 3 and 5 of Figure 14 (spherical, aspherical, convex, concave or following any pattern desired by designer) but allow a perfect control of other design parameters such as the distance x, said distance is usually equal to the focal length of the plenoptic lenses 5, but depending on the algorithms used that distance can be made higher or shorter. For example, in Figure 15 this distance is reduced as compared to Figure 14 (enabling algorithms that allow higher discrimination in terms of number of pixels, but lower discrimination regarding directionality of the rays incident on the sensor).

Instead of plenoptic microlenses 5 (which we named in contrast to the pixel microlenses 3) of a biconvex form, sometimes lenses with convex-plane shapes are used, as shown in Figure 16 (where an implementation with two layers with low refractive index between the microlenses 3 and 5 is used (labeled in Figure 16 "Refractive Index 2" and "Refractive Index 3"), the pixel microlenses 3 and plenoptic microlenses 5 are built with materials of high refractive index (labeled in Figure 16 "Refractive Index 1" and " Refractive Index 4"), with the sole aim of providing more flexibility to the manufacturing process and to the interfaces between different refractive indices).

The flexibilities offered by manufacturing methods for optics similar to those offered by microelectronics are endless, for example Figure 17 shows a structure with only the pixel microlenses and over them the plenoptics microlenses, in said Figure both the first and the second are spherical while in Figure 18 the plenoptic microlenses have an aspheric structure. The z distance between the centers of the "plenoptic semispheres" and the centers of the " pixel semispheres" in the figures 17 and 18 is equal to zero (both semispheres rest on the substrate), but the plenoptic hemispheres might be placed at a longer distance from the substrate, creating structures similar to those of FIG 8.C.

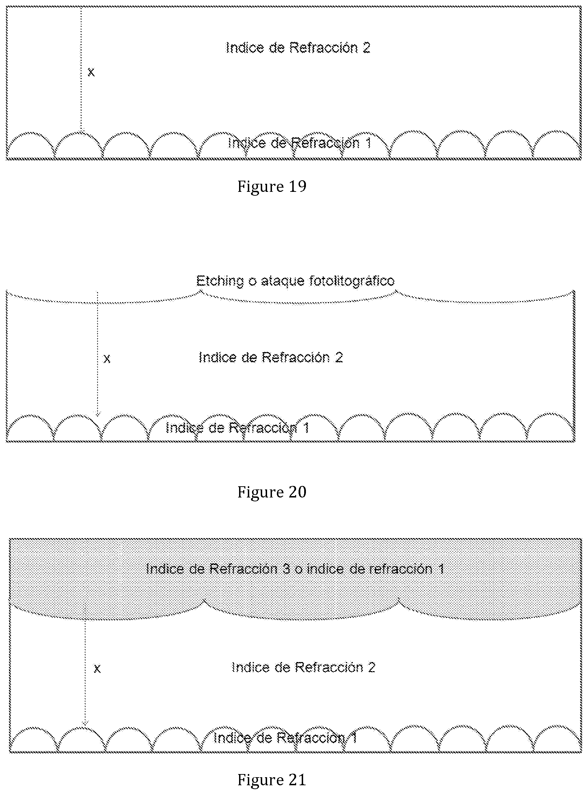

Figures 19 to 22 show a possible manufacturing flow that enables wafer-level processing, providing the ability to manufacture a large number of sensors of very high quality at very low prices.

The figures do not show the substrate containing the array of photo-sensors or the manufacture of color filters and their associated pixel micro-lenses, since these structures have been very widely known in existing products, and as they will be discussed after the detailed description of the structures of the invention.

We start, Figure 19, from the photo-sensor substrate, with its pixel lenses with high refractive index (labeled in the figure as "refractive index 1") to focus the beam of rays on the photosensitive area of the photosensor, above said pixel lenses a photo-resistive transparent material with low refractive index (Refractive Index 2) is placed, as shown in Figure 19. The refractive indices of the pixel microlenses, usually based on transparent resins can have values around 1.5, while there are other materials and meta-materials that can have values around 1.1 or even lower. The distance x can be made larger or smaller depending on the number of coatings. The structure of Figure 19 is processed with selective lighting, followed by etching with a selective attack (dependent upon previous selective lighting), resulting in the structure of Figure 20, have in mind that the "Refractive Index 2" material deposited in Figure 19 can be attacked in a selective manner through a photo-lithographic process.

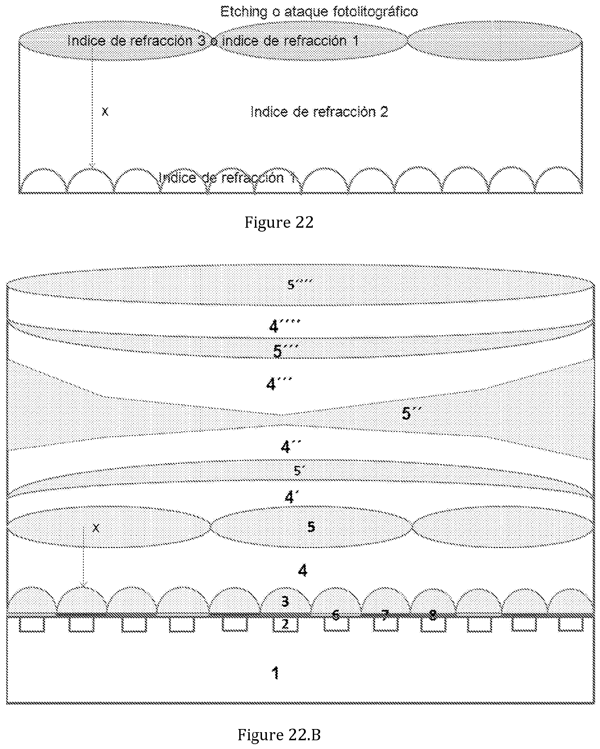

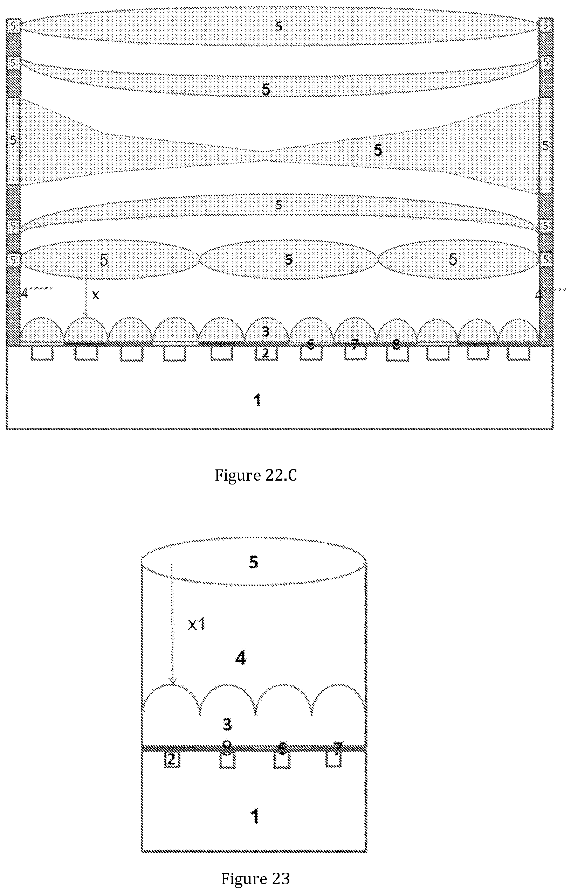

A transparent photo-resistive material of high refractive index layer is placed on top the structure of Figure 20 (labeled "Refractive Index 3 or Refractive Index 1" in Figure 21), resulting in the structure of Figure 21. This material with high refractive index may be similar or even the same material with which were built the pixel microlenses (Refractive Index-1); the next step is a new photolithography process (selective lighting and etching), ultimately resulting in the structure of Figure 22, said structure is a monolithic version (built on a single chip) of the traditional plenoptic structure disclosed in Figures 2, 3, 4, 6.A, 6.B, 8. and 8.B; and as such susceptible to apply the same algorithms of recognition of the direction of arrival of the rays, refocusing, distances from the camera to the points in the object world, etc.

Being able to use methods typically used in microelectronics manufacturing, leading to micro-optical structures formed by elements with different refractive indices, as well as an easy control of tolerances with advanced manufacturing processes used in microelectronics, makes the invention extremely flexible to be adapted to different design trade-offs in terms of manufacturing processes or different price-quality relationships.

For example, the manufacturing processes using CCD or CMOS very mature, and therefore with infrastructure of manufacturing already paid and likely to offer very low cost for applications where the sophistication and quality are not fundamental, this may lead to structures as described in Figure 23: they are mature processes where the size of bias, reading and writing circuits are relatively high as compared to the overall dimensions, the photo-sensors 2 occupy a percentage relatively low of the total area of the substrate 1 (as compared to for example figure 14, where we can appreciate a more advance microelectronic process, in which the dimensions of the electronic circuits have been reduced, occupying a relatively lower percentage of the the total area of the substrate 1). This structure, described in Figure 23, will require a greater distance between the surface of the substrate (e.g. silicon in CMOS processes) and the surface of the pixel microlenses (with a distance between the pixel microlenses and the plenoptic microlenses (x1) which can be equal or different from Figure 14), since the incident light beam should be focused on a smaller area, and that is the reason why the material 3 has increased thickness in the Figure 23. This can be done in a relatively straightforward way by processing optical materials in a similar way as microelectronic materials, such as the deposition of thicker transparent materials followed by a photo-lithography (illumination and etching) to create surfaces of the microlenses with very high precision for both spherical and aspheric microlenses.

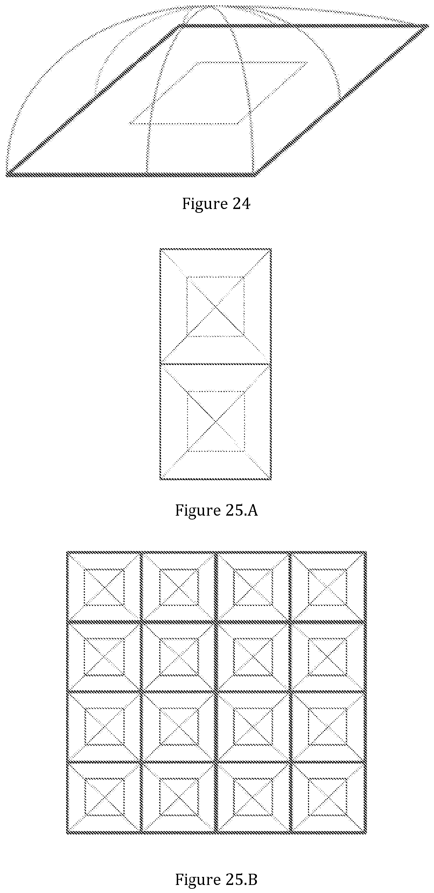

Figure 24 shows how is built a micro-lens on a square area of a photo-sensor substrate (the square of the line with smaller thickness is the active area of the photo-sensor), the high precision of the photolithographic processes enables designing and manufacturing spherical lenses with square bases rather than hemispherical lenses with circular bases. Such manufacturing processes allow structures in which the lens over the photo-sensor, instead of placing a single hemisphere, places 4 parts of the hemisphere intersecting each other in 4 lines. Figure 25.A shows two pixels built next to each other, the thin square lines are the photo-sensors built in the substrate (such as a CMOS substrate), between said photo-sensors and the squares of thick line appears the area of the substrate reserved for bias, electronics and reading circuitry, the blades (in X shape) placed at the upper part represent the intersections between the four hemispherical portions constituting each micro-lens associated with each pixel.

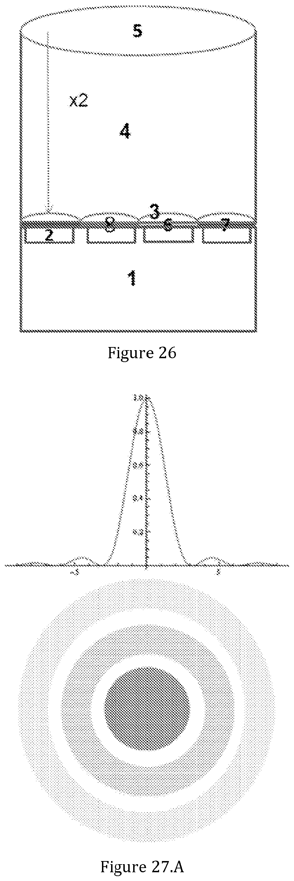

Figure 25.B shows a top view of an array of 4 by 4 pixels, Figure 26 shows a transverse view of the structure, also showing the plenoptic lens 5, located at a distance x2 of the pixel lens 3 with a transparent material of low refractive index 4 between the plenoptic lens 5 and the pixel lens 3. In this example, each micro-lens 5 of the array plenoptic microlens contains 16 pixels (4 by 4). We can also see that the process of microelectronic fabrication has evolved into denser structures (more sub-micron), increasing the percentage of area used for the photo-sensors 2 to the total area of the substrate 1. The vertical size of the pixel microlenses has also been reduced when increasing the percentage of area 2 (since the light beam incident on the pixel micro-lens 3 does not need as much vertical distance to concentrate over the area of the photo-sensor 2. Optional filters of the three fundamental colors (8, 6 and 7) remain in place in case of a color sensor.

The different optical layers can be formed by processes well known in prior art such as CVD (Chemical Vapor Deposition), LPCVD (Low Pressure Chemical Vapor Deposition), PECVD (Plasma Enhanced Chemical Vapor Deposition), HIDPCVD (High Density Plasma Chemical Vapor Deposition) or other deposition processes of materials commonly used in microelectronics, as can be a simple deposition by gravitational force of a molten material, methods used in this case to conduct depositions of optical materials.

We discuss below the optical materials used or usable for carrying out the invention emphasizing that these are just examples that by no means are intended to restrict the generality of the invention, since it is possible to implement it with the materials cited in the examples, or with alternative materials, including new materials non-existent today.

The plenoptic lenses 5, as well as pixel lenses 3, can be made of photosensitive glass materials, allowing fabrication at wafer level with a large number of image sensors per wafer and minimal human intervention, lowering production costs. The lenses (plenoptic and pixel) can also be manufactured at wafer level with thermoplastic resins, photo-resistive transparent materials or transparent polymers of high refractive index that after etching (with for example chemical attack) they can be cured (with UV light -ultraviolet- or heat curing at high temperature). UV curing can be carried out selectively to then remove uncured portions using a suitable solvent. Is it also possible to use several commercial implementations of hybrid organic-inorganic polymers and/or glues of high refractive index curable by UV light. Solid polymers which can be attacked on uncured areas can be used or liquid polymers that under certain conditions (of temperature or UV illumination) become transparent solids with several refractive indices, thereby resulting in optical structures.

Several materials typically used for the microlenses 3 and 5 have been mentioned, typically have refractive indices higher than 1.5, reaching 2 for some materials, a suitable lens material of high refractive index is silicon nitride (with refractive index 2.0), which can be deposited by a plasma CVD process (Chemical Vapor Deposition), another alternative is to form a polyimide resin film (with a refractive index of 1.6 to 1.7) by depositing the material on the substrate and subsequent centrifugation (spinning), shaping adequate forms to create the lens with suitable solvents to the type of material used, for example silicon nitride is attackable by dry-etching (or dry chemical attack). Fluid materials that evolve to softer materials can be deposited, which subsequently require a curing process (thermal or UV-Ultraviolet) to harden, or deposit melted materials that acquire hardness properties during the solidification process; all these processes are applicable to different types of glasses, plastics, organic-inorganic polymers and the other materials mentioned.

The possibilities offered by microelectronic manufacturing processes give the designer the flexibility to build lenses with different materials, with different Abbe number, different dispersion characteristics, with variable diameter (pitch), or with different refractive indices, circular lenses (or hemispherical/semi-aspherical if we watch them in 3 dimensions), square-base-lenses (overlapping four spherical/aspherical quarter-caps intersecting each other if we watch them in three dimensions), hexagonal (six overlapping spherical/aspherical caps intersecting each other if we watch them in 3 dimensions), including triangular shapes, the same is true of the design of the pixels, opening the possibility for the design of novel topologies that are provide better efficiencies for the plenoptic algorithms and offer better lighting performance (such as for example hexagonal microlenses covering 6 triangular pixels) also expanding the flexibility to offer very flexible designs for achromatic lenses. You can deposit layers of different thicknesses, new layers of different characteristics deposited on previous lenses, ultimately, the design flexibility is much greater than in large discrete optics. Additionally, layers with refractive index close 1 can be created (including air) due to the use of "sacrificial material": on a transparent layer (of material 3, 4 or 5) a photo-resistive material with the required thickness and shape is deposited, over said photo-resistive material a new transparent layer (of material 3, 4 or 5) is created with several openings to allow the entry of a suitable solvent to the buried photo-resistive material, which can be subsequently dissolved and removed later. Despite the flexibility offered to the designer to achieve refractive indices close to 1, even air layers between materials of high refractive index, said design must necessarily include "support columns between the two layers of transparent material (3 and 5), as for example shown in Figure 14.b, with all the drawbacks that this entails (presence of "columns" of high refractive index 4' between the two layers 3 and 5; or a structure with possible mechanical problems due to the low abundance of said columns of mechanical support between layers of higher index of refraction). More attractive is the use of meta-materials (instead of air or gases), providing refractive indices which may be even lower than 1. The expendable material may be water-soluble gels, several commercially available already, or conventional photo-resistive materials very widely commercialized for the manufacture of integrated circuits (soluble in water, acetone or isopropanol).

The material 4 can be any transparent material of low refractive index. In order to reduce the distance between the plenoptic lenses and the pixel lenses (x in Figure 14) as well as the size of the pixel lenses, the ratios between the refractive indices of the materials 5 and 4 (as well as also 3 and 4) should be as high as possible. The possibilities for the transparent layers 4 of low refractive index are glass, plastics, inorganic copolymers or organic polymers, with refractive indices of about 1.5.

A well-known method to reduce the refractive index of an organic polymer is to provide a composition with higher fluorine content, however this fact gives to the material lower solubility to water and oils and makes it difficult to have tight bonding in interfaces between materials with high and low refractive indexes, a possible solution to this problem is to bathe the transparent surface of high refractive index on which we will place the material with low refractive index (or the low refractive index surface on which the material with high refractive index is to be placed) with a plasma treatment rich in oxygen (in an atmosphere with high oxygen content); however, if this process is not carried out in a very controlled manner, it can lead to problems of adhesiveness, deteriorating the quality and the manufacturing yield. That is why the fluorine-organic or fluorine-inorganic compounds are commonly used only in the first layers immediately above the sensors, despite their low refractive index (1.3 or 1.4 for acrylic fluorine-resin films, usually formed by centrifugation -spin coating- or magnesium fluoride films typically deposited by sputtering), forming "sandwiches" with layers of various refractive indices (although simplified in the figures where only a single layer has been placed) based not only on the design criteria of the refractive index but also in adhesiveness criteria between layers.

Other transparent materials used immediately upon the photo-sensors can be (in a single layer or multilayer structures, which may include a passivation layer and/or planarization) those which traditionally have been used in the dielectric between the metal layers and/or polysilicon normally used to establish interconnections between active elements of the chips, materials such as silicon oxide, FSG (Fluorinated Silicate Glass), oxide doped with carbon, MSQ (Methyl-Silsesqui -Oxane), HSQ (Hydrogen Silse Quioxane), FTEOS (Fluoro Tetra Ethyl Ortho Silicate) or BPSG (Boron-Phosphorus Silicate glass), the latter usually formed by a thermal reflow process (reflux) around 900 degrees Celsius, the above formed by CVD, LPCVD, PECVD, HIPCVD, or other well-known methods in prior art deposition. The passivation or planarization layer (not exposed in the figures for simplicity and for being well known in the art) may be formed of various compounds, such as silicon nitride (SiN or Si3N4), silicon oxynitride (SiON), Silicon carbide (SiC), silicon Oxi carbide (SiOC) or other combinations with similar properties. Color filters are generally protected by placing additional cover layers of silicon oxide or combinations thereof, not drawn in the figures for the sake of simplicity, it can be deposited by CVD, LPCVD, PECVD, HDPCVD or other deposition processes well known in the art.

We explain below a manufacturing process proposed for the invention in order to obtain similar structures to those shown in Figure 14, with reference to the manufacturing process sequence set forth in Figures 19, 20, 21 and 22. We start with a substrate of photo-sensors 1, including its photo-sensors array 2, its color filters (6, 7 and 8) and its pixel lens 3, a structure well known in the art and widely used in CMOS processes, although the invention could be applied to various other structures. On said structure (Figure 19) offering a high refractive index for the pixel lenses (Refractive Index 1) a material of low refractive index (refractive index 2) is positioned with a thickness x decided in the design process. This layer may be a single layer or a "sandwich of layers" such as that shown in Figure 16, in which for example a first layer of low refractive index (refractive index 2) has been added using processes such as XCVD, deposition-centrifugation or other well-known processes in prior art, and on that layer a substrate also of a low refractive index (refractive index 3 in Figure 16) has been bonded.

Over the structure of Figure 19 we place, for example, a photosensitive layer with a material as a positive photo-resistor, said photo-resistor layer is positioned over the "Refractive Index 2" layer. Said photosensitive layer is exposed selectively to light using a gray mask, for example illuminating with I-line lamps (lamps with mercury vapor at very high pressure), so the structure is exposed to different light intensities, upon exposure to light and subsequent etching the layer of photo-resistive material provides exactly the same curvature of the top of Figure 20. After etching the photo-resistive material layer, attacked for example with a chemical attack using dry etching solvents (a dry etching process), which typically involves bombing the layer with ions (typically a plasma of reactive gases such as fluorine-carbonates, oxygen, chlorine, boron trichloride and occasionally adding hydrogen, argon, helium and other gases). This attack, in addition to "cleaning" the photosensitive material begins to "clean" (empty) the material of the lower layer, transferring to the low refractive index layer 4 ("Refractive Index 2" in Figure 19) the same curve that was initially formed in the photo-resistive material. The accuracy and reproducibility using dry etching are excellent. Liquid solvents could also be used, but they attack in a more anisotropic way. In Figure 20 we have obtained a concave structure, but as we shall see later convex structures could have been obtained.

Finally, a third layer of material with high refractive index is created ("Refractive Index 3 or refractive index 1" in Figure 21), which can be deposited with techniques similar to those explained above, such as CVD, LPCVD, PECVD, HDPCVD or other deposition processes well known in the art. If this layer "Refractive Index 3 or refractive index 1" has been deposited with a photosensitive transparent material (resin, glass or other photo-sensitive materials) it is enough to expose said structure to a light exposure process similar to that described above. to thereafter attack said layer and selectively dissolve the material, resulting in the final structure of Figure 22 (a plenoptic structure obtained using manufacturing processes typically used in microelectronics). Another alternative is to repeat the process previously used to place over the structure of Figure 21 a layer of photo-resistive material, treating it with selective illumination, for example with a mask of grey levels, and processing the resulting structure with an attack with for example dry-etching (attacking it with dry solvents), not only to clean away from the structure the photo-resistive material, but to transfer to the high refractive index layer 5 (labelled in Figure 22 "Refractive Index 3 or Refractive Index 1") the profile initially created in the photo-resistive material.

The invention has been described with an example of a particular photo-lithography, but other known or future photolithographic techniques can also be used, such as EUV (Extreme Ultra Violet) of which can be expected definitions reaching 13.5 nanometers and below.

The upper optical layers of Figures 14, 15, 16, 17 and 18 may also be constructed by replication techniques, that is, in a mold with the negative of the shape of the lenses a fluid polymer is poured (polymer which may be viscous or liquid at room temperature), on said mold filled with the polymer the wafer sensor is placed in inverted form (with the photosensors 2 facing down), so that the wafer has physical contact with the polymer-liquid or viscous (on the side of the photo-sensors 2 and the pixel lenses 3), solidifying then the polymer by exposure to ultraviolet light or by high temperatures. The polymer will result in a transparent solid with a suitable refractive index, thus forming the matrix of plenoptic microlenses.

Color filters are created by depositing layers of each of the three colors by consecutive photolithographic processes, to then cover all with a protective layer or passivation.

There is the possibility of placing at the top of the plenoptic microlenses, the pixel microlenses and elsewhere, layers of anti-reflective coating, thus helping to improve the luminous efficiency of the structures, as well as IR (infra-red) filters, in order to improve the signal/noise ratio in the photo-sensors by filtering the unwanted portion of the spectrum.

Pixel lenses are manufactured with similar methods as those described for the plenoptic lenses.

The processes described above, together with other techniques and instruments in optics and microelectronics, such as mechanical stamping of glass (at cold and high temperature), heat-reflux, ultra-precise molding tools, laser marking and other processes well known in the state of the art in optics and in microelectronics, lead to processes, tools and results extremely sophisticated, accurate and cost effective, providing the designer possibilities of axial tolerance (along the z axis) fixed by the tolerances of the thickness of the layers. The tolerances of the side mounting (along the x and y axes) are determined by the accuracy of the photolithographic masks (able to replicate very high volumes, hundreds of millions of units, patterns as small as 28 nm and lower in the near future), leading to products integrated monolithically with extremely simple manufacturing technology that will make miniature products compete and overcome some of the features in optical products with large size and weight. As an example, it can be said that with tolerances of the order of nanometers in the physical implementation of micro-lenses, aberrations can be much lower than in larger cameras.

Optical wafers and sensor wafers can be manufactured separately and subsequently bonded together (by welding, anodic bonding processes or gluing processes) by taking profit of "alignment marks" in both wafers and providing great precision using modern mask aligners; it is also possible creating optical layers with different patterns over the sensor wafer by deposition techniques, epitaxial growth or other techniques well known in the art.

As in microelectronics for the fabrication of integrated circuits, or in any manufacturing process of image sensor (CMOS, CCD, or any other) the last steps consist in cutting (dicing) the wafer into several individual chips and a final encapsulating, usually with a plastic or ceramic package (which includes an opening with a transparent material on top to let light through to the sensor), and metal pins for electrical interconnection of the chip with the outside system, or in the case of chips with very high density of pins, instead of metal pins an array of solder balls located on the bottom of the chip can be used (BGA or ball grid array) similar to the solder balls in the bottom of Figure 13; even at the cost of more expensive unit costs, depending on the manufacturing processes and the availability of certain instruments, it would also be possible to perform the cutting process (dicing) for the optical wafer and for the electronic wafer separately, and place each optical device over each sensor before the encapsulation process.

There are several practical problems in miniaturization that the disclosed invention solve in a more appropriate way than other technologies. The outer lenses leading incident light to a sensor as proposed, or any other sensor in general, due to the trend to reduce the thickness of the sensor (with a total thickness less than 1 cm, or even less, as for example to be a part in a mobile phone) receiving the bundles of light rays in a less perpendicular manner on the plenoptic microlenses at the periphery of the array than on the microlenses at the center of the array, so that light is not directed efficiently toward the photo-sensors, giving a maximum efficiency in the center of the photo-sensor and deteriorating gradually towards its periphery. Light incident on the plenoptic microlenses at the periphery of the array is more tilted than in the center of the array, resulting in a shallower focal length seen from the pixels in the periphery of the photo-sensor as compared to the pixels at the center the photo-sensor. There are three ways to solve this problem, the first is to space the photo-sensor pixels differently in the periphery than in the center of the array (placing the "disks" or "square" or "hexagons" or "any geometric shape" designed for the pixels corresponding to the plenoptic microlenses at the periphery of the array farther away of their adjacent "disks, or squares or hexagonsr" than at the central zone), while increasing at the same time the area of the pixels at the periphery of the sensor as compared to the pixels at the center of the sensor. This solution is not efficient because it increases the area of the substrate (e.g. silicon in a CMOS process) and increases the cost of the product, but decided to mention it.

The second solution to the problem described in the previous paragraph is a design of the plenoptic microlenses with different profiles at the center than at the periphery of plenoptic array, in order to ensure higher deviations for the less perpendicular beams at the periphery than at the center of the plenoptic array; with this measure only the lens at the center array would be perfectly symmetrical about its axis, and gradually as it moves towards the periphery of the plenoptic array, the microlenses are increasingly asymmetrical with respect to its axis to ensure that the perpendicularity of the beams at their photo-sensors is exactly and equally efficient in its central region as in its periphery. This solution, a practically unfeasible implementation in discrete optics, is extremely efficient and easy to implement using photolithographic processes for the manufacture of micro-lenses as those set forth in the invention.

A third solution is to gradually vary the distance between the microlenses and the sensor (parameter x in Figure 14) so that said distance is smaller at the periphery of the plenoptic array than at its center. Only a single micro-lens (or two or four at most) is (are) perpendicular to the optical axis of the system, the micro-lens at the center of the sensor, since x is variable in other micro- lenses increasingly tilted versus the optical axis and ever closer to the plane of the sensors as we move away from the center of plenoptic array. This solution, also virtually unfeasible in discrete optics, is efficient and easily implemented using photolithographic processes.

A mixed solution among those discussed in the preceding paragraphs is the most efficient from the point of view of maximizing optical efficiency and minimizing optical aberrations, aberrations already very low due to the efficiency in the control of distances and the shape of the lenses thanks to the use of photolithographic processes.

Depending on the processes and materials available it is possible to manufacture as well structures as the one from Figure 14.b, where the material in layer 4 (with low refractive index) has been replaced by air (or other inert gaseous materials, non-corrosive and with good properties against moisture penetrations); the distance between the photo-sensors 2 (or its associated lens 3) and the "microlens array" 5 is maintained thanks to the spacers 4'. This structure is also relatively simple and offers low cost manufacturing using "wafer stacking" techniques: on a usual state of the art photo-sensors wafer (containing the substrate 1, the photo-sensors 2, color filters 6, 7 and 8, and optionally the microlenses 3) a second wafer with spacers (4') is placed, and on this a third wafer with the microlenses 5 is further placed. The mask alignment techniques for manufacturing process and the wafer alignment in microelectronic manufacturing processes lead to excellent results when aligning optical wafers and when aligning electronic wafers with optical wafers. Usually standard wafers of 8 or 12 inches are used.

The material of the spacer wafer 4' should absorb light, avoiding any kind of reflection that would lead to "double images"; this objective can be accomplished in a simple way such as the coating of the side walls of the separator 4' with anti-reflective material, for example by spraying. Wafer separator 4' may be attached to the sensor wafer by welding, anodic bonding, by temperature treatment or by adhesive resins which can be cured by ultraviolet light or hardened with temperature; deposition of these resins must be symmetrical to the optical axis, avoiding the areas of the optical path of the light towards the sensor in a selective manner by printing or spraying techniques. The microlenses 5 wafer is fixed to the separator 4' in a similar way as described.

The spacer wafer 4 'is manufactured etching (physical or chemical attacks) a glass substrate of the same dimensions as the sensors wafer (usually 8 or 12 inches), the openings also may be performed by laser cutting, high pressure sand jets or ultrasonic drilling.

The material 4' and 5 may be constructed in another embodiment as a single piece rather than as two separate pieces. Thus, the wafer 5 + 4' is placed on the photo-sensing wafer (1 + 2 + 6 + 7 + 8 + 3).

As an alternative to the manufacture of the optical wafer spacers (4'), these can be constructed by depositing a dry photo-resistive material over the semiconductor substrate (already with the color filters and the pixel lenses) and a subsequent chemical or physical attack (etching) to open the separating gaps which will align the pixel lenses (3) with the plenoptic microlenses.

There are many methods to manufacture the plenoptic microlens wafer 5. Although in Figure 14.b only the final product can be seen, this may be obtained thanks to using a thin substrate having convex-flat microlenses formed on its top portion and flat convex on its bottom portion. The microlenses can be manufactured with organic materials of glass, epoxy, or silicone or acrylic materials. The microlenses may also be formed by replication processes where polymers or curable liquids are used (curable by UV light or heat), the microlenses can be built on a thin transparent substrate of glass, plastic, quartz or resin. This way spherical, aspherical lenses or otherwise can be built. They can also be constructed by techniques of photolithography attack of materials sensitive to chemical or physical attacks, or depositing photo-resistive materials on the substrate of the microlenses, etching them to give them the shape of the lenses by using a gray mask, to then subject the structure to a physical or chemical attack (etching) in order to take the shape of photo-resistive material which subsequently form the lens materials; performing the process on one side of the microlenses wafer or on both sides.

After the alignment and bonding of the plenoptic microlenses wafer 5 to the separators wafer 4' we can proceed to cutting (dicing), or separation of each of the plenoptic sensors contained in the wafer.

The microlenses 5 on top of the structure may be covered with layers to filter IR (infra-red) light, thereby increasing the signal/noise ratio of the photo-sensors. The use of anti-reflective coatings prevents that part of the incident light output does not reach the sensor.

The plenoptic algorithms used by the technology described in Figure 14.b place the sensors' plane at a distance less than the focal length of the input optical system.

The biggest impact from the disclosed invention leads to the use of meta-materials as part of the micro-optical processes described; thanks to the use of materials with no negative refractive index but only of materials with positive refractive index lower than 1, can drastically reduce the dimensions of the optics. Referring to Figure 14, if the refractive index of the layer 4 is made for example 0.5 or 0.1 the distance x would be drastically reduced, making feasible a monolithic integration with unprecedented thicknesses (particularly suitable for fields such as mobile phone, demanding sensors with very small dimensions). Monolithic sensors (by integrating electronic and optics) in which the distance between the pixel microlenses 3 and the surface microlenses 5 is of three millimeters have been manufactured, to keep increasing the size of the integrated sensors to reach the size that would be achieved with discrete optical devices of small size (as in Figure 11) can result in wafers with an excessive thickness, great difficulties in the cutting process (dicing) and mechanical instabilities, deteriorating the yield of the manufacturing process, increasing costs and the size of the monolithic structure.

However, the use of meta-materials with refractive index lower than 1 not only reduces the distance x between the pixel microlenses and the plenoptic microlenses (Figure 22.B) but allows to be brought into a thickness acceptable to the manufacturing processes described in the invention (a few millimeters) and a higher number of lenses as part of a single monolithic sensor. Referring to Figure 22.B, the use of a meta-material 4 with a refractive index of less than 1 decreases the distance x, and enables the deposition of a second layer of meta-material 4' on the plenoptic microlenses, on which for example can be constructed concave/convex lenses 5', or bi-concave lenses 5", or concave/convex lenses 5''' or bi-convex lenses 5'''', or a combination of several lenses within a "sandwich" structure similar to that depicted in Figure 22.B, resulting in a monolithic sensor that integrates all lenses of a micro-camera, which thanks to the use of photolithographic techniques described in the invention, rivals in some features, such as optical aberrations and lighting efficiency, with their large discrete counterparts, these cameras beat large cameras in terms of production ease for very high volumes at low cost.

The order in which the different lenses are deposited may be any suitable for the designer, so the structure of Figure 22.B is a micro-optical structure equivalent to figure 6.B (except to the zoom, which can also be constructed micro-optically, as discussed below); if the layer 5 (Figure 22.B) is at the top of the "optical-sandwich" integrated structures equivalent to those of Figures 5.A and 5.B are reached; or if is placed (immediately below the input lens separating the micro-camera of the object space) micro-optical lenses equivalents to Figures 7.A and 7.C are reached.

Without reaching the extreme size reduction reported in figure 22.B thanks to the use of materials with refractive indices below 1, monolithically integrated cameras as described in Figure 22.C are obtained (where gaps between layers are not drawn to the same scale as in 22.B). Materials of low refractive index (4) of Figure 22.B were replaced with air (or other gas), and the spacing between the high refractive index lenses (5), including the plenoptic microlenses, are guaranteed thanks to the use of spacing wafers 4'''', so that over the sensors wafer (including layers 1, 2, 6, 7, 8 and optionally 3) is located a first spacing wafer 4'''', on which is located a plenoptic microlenses wafer 5, over this a second spacing wafer which is placed supports for placement of a first lens (convex-concave in this example), and so on, building a micro-camera of excellent performance suitable for use in portable devices (mobile phones, laptops, tablets, etc., etc.). This invention is a super-set of the depicted in Figure 14.b, through the addition of more lenses by stacking optical wafers on the sensor wafer and the first plenoptic lens wafer.

Manufacturing techniques have already been exposed when describing Figure 14.b, we explain below various possibilities for the manufacture of lens wafers in the upper layers of Figure 22.C, some widely described by Wolterink, Dohmen Sander Van Der Sijde, Arjen De Bruin, Groot and Anton Van Arendonk in WO 2004/027880 A2. With the materials described when explaining figure 14.b it is possible to form convex optical elements on a thin transparent substrate by using replication techniques, thus giving rise to plano-convex lenses (spherical, aspherical or anamorphic). Using replication techniques it is also possible to build lenses on a substrate of non-transparent material in which openings (gaps to let light pass through) of the same dimensions as the sensor have been conducted (in a similar manner as would a slice of a Swiss cheese with lenses in its holes , but obviously with holes for the passage of light designed in a more regular basis), the non-transparent substrate prevents the "noise-light" reaching the sensor; for example convex-concave lenses may be replicated in openings of the substrate, thereby reducing the thickness of the resulting micro-objective. Another less efficient way to build convex-concave lenses is to replicate on top of the transparent substrate a fine convex surface, with a corresponding concavity replicated at the bottom of the substratesubstrate. Optical wafers with any profile may be constructed as described, not just those shown in Figure 22.C but any anamorphic lens. Stacking wafers as the ones described above, or using any other combination easily extrapolated by experts in optics, it is possible to manufacture almost any type of monolithically integrated mini-camera.

Besides the techniques described in paragraph above, wafers with glass or transparent photosensitive materials with high refractive indices which can be attacked by photolithographic techniques well known in the prior art are manufactured, leading to any type of lenses with any profile manufactured at both sides of the lens, with enviable aberrations compared to manufacturing methods for lenses of large size due to the small size tolerances achievable using photolithographic techniques. Another possibility is to deposit a photo-resistive material on the optical wafer, exposing then the material to gray masks, etching in order to create the desired optical profile of the lens on the photo-resistive material, to then proceed with a physical or chemical attack (etching), that will not only remove the photo-resistive material, but reproduce the profile of the surface obtained photolithographically on the optical substrate. This technique results in lenses without any possible comparison with the state of the prior art, neither in size nor in aberrations.

The order in which the wafers are stacked and the optical layers of the sensor (or micro-camera) built is not necessarily that illustrated in Figures 22.B and 22.C, for example, the microlenses wafer could be last instead of the first (counting from the surface of the pixel lenses), resulting in a monolithic implementation similar to the discrete implementation (with discrete lenses) in Figure 5.

A; in another example the wafer with plenoptic microlenses could be between the input lens and the other lenses (these located between the MLA and the sensor), resulting in a monolithic implementation of the structure in Figures 7.A, 7.B and 7.C.

Mixed solutions between the figures 22.B and 22.C are also possible, where the lenses closest to the sensor are constructed by depositing alternate low and high refractive index layers, while the more remote layers of the sensor are constructed by spacers and stacking wafers. The microlenses can be part of the first structure (obtained by growth of optical layers over the sensor) or the second structure (obtained by stacking wafers). Any permutation, in the order of layers as well as in the manufacturing technique is possible.

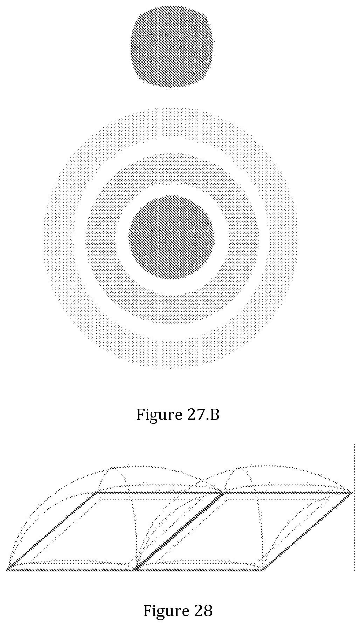

A completely different field of innovation in this invention is in the number of megapixels that can be integrated (both, for large cameras and for mini-cameras for mobile phones, tablets and handheld devices), theoretically following Moore's Law applied in microelectronics, but in practice limited by light inefficiency of very small pixels, the size of the pixels cannot decrease indefinitely, because for very small dimensions the wave nature of light begins to manifest, the light beams over the pixels (photo-sensor) produced by the objectives, the plenoptic micro-lenses and the pixel microlenses do not exhibit a constant density of light independent of the distances over the sensor surface, the power density has a form like that of Figure 27.A (assuming circular lenses in the light path), with a central region where most of the energy is concentrated (at the center of the pixel, called the Airy circle, dark gray area at the bottom of Figure 27.A), and side lobes increasingly smaller as we move away from the center pixel (Airy rings, concentric rings in whiter gray at the bottom of Figure 27.A). It is well known that in an optical system whose exit pupil is circular, the irradiance distribution associated with the image of a point object is constituted by a central circular lobe in which most of the energy is concentrated (84 %), and a series of concentric rings of decreasing intensity.

In one of the described implementations, as pixel lenses are not perfect hemispheres (or semi-aspheres), but four hemispherical (or semi-aspherical) sectors intersecting each other to focus the light beam onto a photo-sensor square (see Figure 24), Airy circles and rings are not perfect circles but four circular sectors composing what we call a 'cuadri-circle "as seen in the top of Figure 27. B (compared with a usual Airy circle at the bottom of the figure). But such peculiarity does not diminish the generality of the invention described below. If the pixel lenses were hexagonal it would lead to a power distribution in a "hexa-circle" shape.

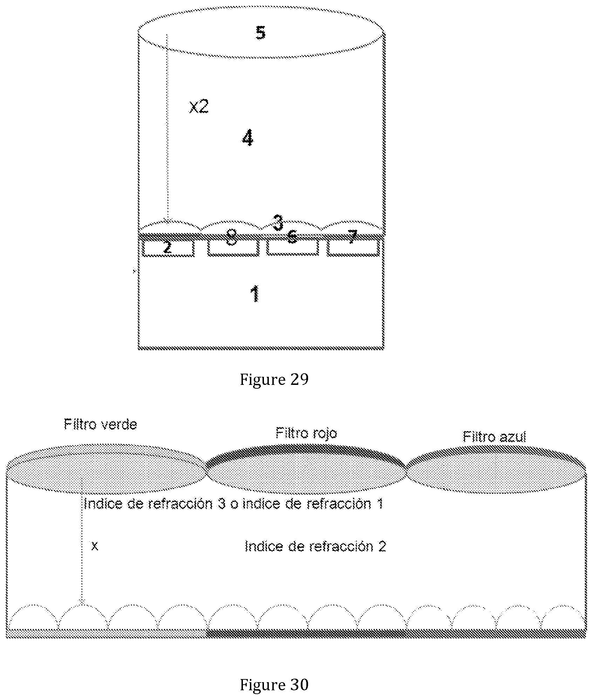

If the pixel size (the micro-lens size and/or the photo sensor size) becomes so small as the main lobe of light energy (the Airy circle of Figures 27.A or 27.B), the secondary lobes (Airy rings figure 27.A, or "quadri-rings" in Figure 27.B) may eventually fall into adjacent pixels instead of over the correct photo-sensor, leading to interference between pixels. Before coming to the phenomenon of interference between points, depending among other things on the ratio between refractive indices, it is possible that the microlenses (hemispheres, or rather "quadri-spheres", consisting of four spherical sectors or aspherical, or "hexa-spheres" in case of hexagonal microlenses, or trian-spheres or other geometric shape) between adjacent pixels come to overlap, as seen in Figure 28, which illustrates a deep sub-micron process, where the area of the photo-sensor is very high compared with the total area of the substrate (photo-sensor and bias and reading circuits). The fact that the two hemispheres (or two aspherical lenses or two quadri-spheres) of two adjacent pixels overlap, has no negative effect, rather it is a positive effect, as if the area of the photo-sensor is very small compared to the total area of the substrate, the thickness of the material in the vertical direction of the pixel micro-lens (3) would be very high, increasing the total size of the structure. In this case, the thickness of the pixel micro-lens 3 in the vertical direction is so low, and the space in the vertical direction from the surface of the micro-lens to the pixel photo-sensor is so small that a with a very low thickness of the structure we take virtually 100% of the light energy received through the main camera lens to the useful surface of the photo-sensors. A difference from some of the structures seen above is that the limits of the upper surface of the microlenses 3, at the lowest part of their profile does not actually touch the substrate 1, making that at the intersection lines between the surfaces of two adjacent microlenses the low refractive index material 4 is always located at a minimum distance of the substrate 1, as illustrated in Figures 28 and 29.

When specifying a design of very small dimensions, where the camera would form part of an apparatus of very small dimensions and at the same time we were obliged to have a very large number of pixels, reducing size can reach the extreme end where the size of each of the photo-sensors may be required to reach similar to the width of the main lobe of Figure 27. In this case we have to accept that there will be some inter-pixel noise, if it is low enough there is no reason to have a noticeable deterioration of the quality of the image, we must also accept that light energy that reaches the photo-sensors will not be 100% of the incident energy.

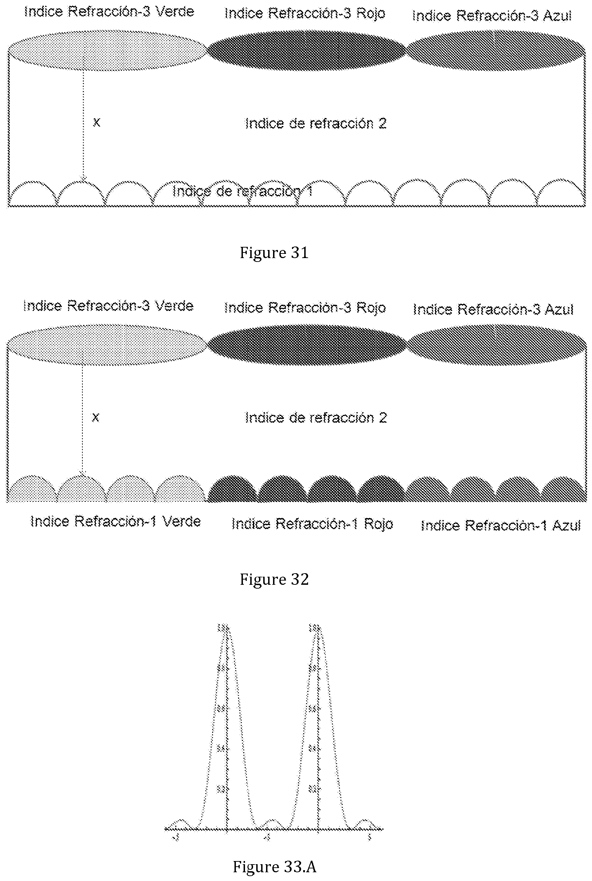

In fact, approaching such dimensions (close to a few microns, even slightly below the micron) in most cases the richness of image details can only be appreciated thanks to the zooms held in a support computer to display details of a specific area of the image until the pixels become too visible with excessive zooms, under such circumstances a small interference between adjacent pixels, showing a slight change of image detail in the real world, it is not as important as the fact that such details in the real world may have different colors. In this circumstance, if the color filters, instead of being designed pixel by pixel, are designing a micro-lens by micro-lens basis, the effects of interferences between pixels are much less damaging, adopting structures as that of Figure 30. There are several possibilities, one of them is to place the color filters on the plenoptic lenses (top of Figure 30), another possibility is to place the filters (as traditionally done) between the pixel lenses and the photo-sensor (bottom of Figure 30), a third is to use smaller thickness filters by combining the two solutions described (filters under the pixel microlenses and on the plenoptic microlenses). Another possible solution would be for the plenoptic microlenses themselves not only to be constructed of a transparent material with high refractive index, but also having color filtering properties of, as shown in Figure 31. It is also possible that the pixel microlenses are also filter micro-lenses (as illustrated at the bottom of Figure 32), or mixed solutions in which filtering is performed in both arrays of microlenses. Such structures are also more efficient under the practical viewpoint, since the dispersion characteristics, refractive index and other optical characteristics of materials used to fabricate the pixel microlenses and the plenoptic microlenses, are not always independent of frequency (color), enabling designs in which the pixel microlentes and plenoptic microlenses are different and optimized for each color, and allowing the use of less sophisticated and lower price optical materials.

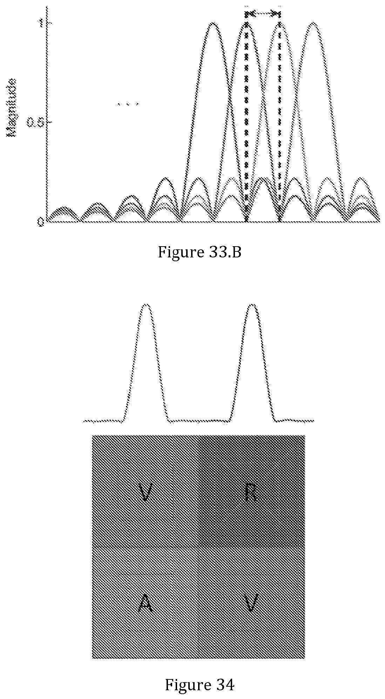

Structures as described in the preceding paragraphs, or structures where side lobes of Figure 27 (Airy rings) will fall on areas of the opaque substrate intended for bias and reading circuits, selecting gaps between pixels such as those shown in Figs 33.A , 34 and 35 are easily obtained thanks to the use of microelectronic fabrication techniques applied to the optical layers as described in the invention. At the demanding extreme of having to increase the number of megapixels in the sensor and having mandatory reduced sizes due to the application, size can go down to the limit to adopt designs as in Figure 33.B, where the center of a pixel could be placed in the valley power of its closest pixels, taking profit of the orthogonality between adjacent pixels colors (different frequency) due to the use of different color filters in adjacent pixels, as will be explained in detail below.

Reaching such extreme size reduction, there are other noise effects that become important, as is the light output in the infrared or near infrared spectrum, although not perceptible to the human eye, is a considerable noise in the photo-sensors; the way to minimize it is to add filters for these frequency ranges. Such filters can be placed at any point (or multiple points) of the optical path, by themselves or in combination with color filters (thanks to the use of filters for not only a color but with very high selectivity for the frequency ranges whose noise is to be avoided), in this way infrared filters can be placed over the plenoptic microlenses, as part of the material of the plenoptic microlenses, between the pixel microlenses and the substrate, as part of the pixel microlenses, over the pixel microlenses, in the material of low refractive index located between the pixel microlenses and the plenoptic microlenses (for example in the material 4 in Figure 29). They can also be constructed by a combination of several of the methods described.

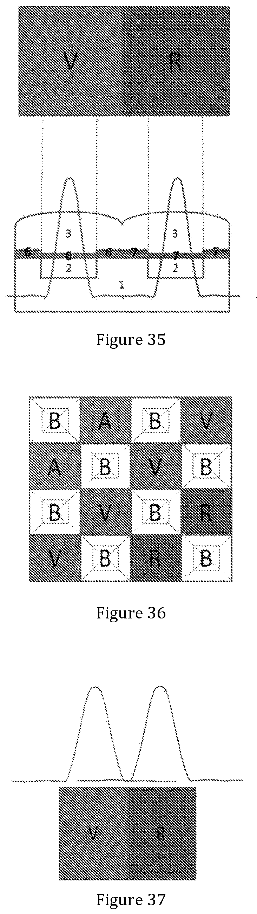

Figure 34 shows the distribution of light energy on 4 adjacent pixels forming a Bayer pattern (a 4 pixels square: green-G, red-R, blue-B, green-G) commonly used for color sensors. At the top of the Figure the irradiance from the microlenses, and their corresponding pixel color filters is shown, in this case we see that the area of the photo-sensor (inner square surrounding the letters G, R, B and G) and the pixel micro- lens are designed so that the main lobe of irradiance falls over the surface of the photo-sensor, and the second and third lobes impinge on an opaque area, thus preventing significant amounts of noise in adjacent photo-sensors. Figure 35 illustrates the phenomenon more clearly (using the notation of the previous figures): on the substrate 1 photo-sensors 2 have been built, and green 6 and red 7 filters have been deposited over them; however, over the "not active substrate area" (the area not used by the photo-sensors, normally used for bias circuits, A/D converters and circuits reading the photo-sensor) a layer of opaque material which does not enable the side lobes to reach the substrate has been deposited, depending on the technology these opaque layers can also play the role of "metal connections" to the photo-sensors (normally used in CMOS processes), but instead of opaque metal they may include other elements normally used or usable in semiconductor manufacturing.

Figure 36 shows the Yotsuba pattern, another pattern typically used in color sensors (with white pixels BX arranged in diagonal, and between them diagonals of green pixels-G, and diagonals with alternate pixels: 2 blue-B and 2 red-R), the discussions held above are also applicable to that pattern.

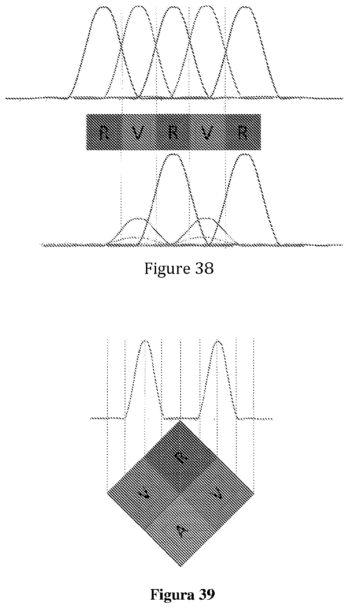

As for example in a CMOS process or other process manufacturing photo-sensors (past, present or future), there is a progress towards more sub-micron technologies, bias circuits, reading circuits and connections get smaller, making it possible to design higher pixel densities in an increasingly smaller space, if at the same time we try to improve the use of the substrate, with areas of photo-sensors having and increasingly higher percentage compared to the total area of the substrate (for obvious reasons of cost, as for example in a CMOS process cost is proportional to the area of silicon)structures as those in Figure 37 can be reached, where the area of the photo-sensor is very high as compared to the total area of the substrate, but we have the problem that the second and third lobes illuminate an adjacent pixel photo-sensor, deteriorating the signal-to-noise-ratio SNR (in terms of inter-pixel noise). Actually the problem is less severe than it appears at first sight because of the orthogonality between colors, as shown in Figure 38, showing a design in which the needs of the application specified very small dimensions for the sensor and a number of pixels per unit area very high, so that it is not possible to further reduce the dimensions of the pixel microlenses or the photo-sensors, because as these dimensions begin to be comparable to the wavelength of the incident light the beam suffers diffraction and the optical structure is not efficient (very few photons reach the photo sensors), and remember that at the time of writing this patent several semiconductor manufacturers have begun manufacturing in volume CMOS technologies with 28-nanometers for the dimensions of the gate of a transistor, obviously photo-sensors of such small sizes would be inefficient, because the wavelengths of light would be substantially higher than the dimensions of the photo-sensor, resulting in diffraction processes that reduce light efficiency in a very significant way.

The urgent need for small size, high packaging and therefore a high number of pixels in a small space has pushed the design of the couple "photo-sensor + pixel micro-lens" so that the peak irradiance of the "pixel micro-lens + filter" falls into the first zero irradiance of adjacent pixels (as illustrated in Figures 38 and 33.B), resulting for example in a Bayer structure in irradiances at the red and green areas on top of the pixels as in Figure 38. However, the problem of inter-pixel interference is minimized by the orthogonality of colors, the bottom of Figure 38 reflects the irradiance of green color after crossing the red filter, an attenuation of 6 dB filtering (solid line, intermediate level lobes) and 10 dB (lowest level lobe dotted line), obviously it is not possible to indefinitely increase the attenuation of the filters, as these would reach a prohibitive thicknesses, however it is easy to get to a situation of acceptable contrasts for most applications.

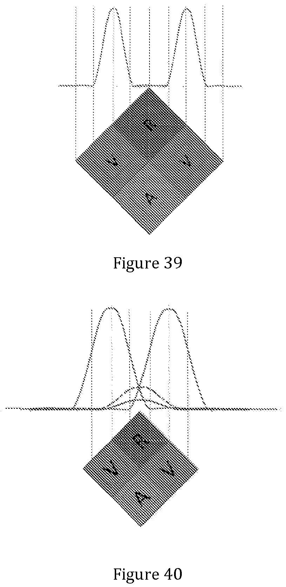

More critical is the interference of neighboring points of the same color as the adjacent pixel noise is not filtered. In this respect the Bayer pattern provides better performance, as only the green pixels have green diagonal neighbors, while in the YOTSUBA pattern all points are neighbors of the same color diagonally. This phenomenon is illustrated in Figure 39, in this case the ratio of area of the photo-sensor to the total area of the substrate is sufficiently low so that the two neighbor green light beams have the power of their first lobe in the area of the photo-sensor, and the second and third lobes illuminate the opaque area between photo-sensors. However, as the need for more pixels in less area pushes it, and sub-micron technologies allow, it comes to situations like the one in Figure 40, which may be good enough for certain applications, but the design criteria have pushed the light beams between adjacent "pixel-microlens/sensor" overlapping each other, not only the overlap attenuated between colors (red -shown with large attenuation in the figurative- and blue with green) but also two beams of green overlapping between them. Remember that it is not possible to design neither the area of the sensors nor the microlenses smaller, since for these dimensions below a certain threshold the wave phenomena start to prevail over the rectilinear propagation, and below these thresholds these structures are not efficient anymore, resulting in multiple refractions and diffractions that prevent the arrival of an appreciable amount of photons to the sensors. At this point we must accept certain inefficiencies, which nevertheless will result in sensors suitable enough for a vast majority of applications requiring very small sizes and high density of pixels per unit area, especially if we minimize the problem with the invention described below. First, Figure 40 shows that not all the main beam irradiance is projected onto sensor area, part of the main lobe falls in the opaque area (a deterioration in the efficiency that we must accept the sake of miniaturization), but even more serious is the fact that the second and third lobes of a green pixel introduces noise into other adjacent green pixel, increasing the inter-pixel noise, as shown in Figure 40, since there is no attenuation filters when neighbor pixels are of the same color. Figure 40 also shows how the red pixel irradiance (and also for the blue, that even if not drawn would be equal) in the green area is greatly attenuated by the filters.

The need for space, the trend towards miniaturization and the increased number of pixels, has pushed to structures where the beams illuminating adjacent pixels overlap with each other, in that situation the wave phenomena, which can be neglected working with higher dimensions, must be taken into account so that the sensors continue to operate. The irradiance of Figure 27.A forms the so called Airy circles on the sensors (or quadri-circles in Figure 27.B in our example of lenses with square pixels, or "trian-circles" when using triangular pixels and pixel lenses), given by the expression:

$$E(\rho') = \left| \frac{J_1(2\pi \frac{n' \sin \sigma'}{\lambda} \rho')}{\pi \frac{n' \sin \sigma'}{\lambda} \rho'} \right|^2$$

where J 1 is the first kind and order one Bessel function, λ the wavelength, n the refractive index, σ the angle of incidence of light rays between the exit pupil and the plane of the photo-sensors and p' the radial coordinate at the image plane.

The first zero of the function appears on $\rho_1' = 0,61\lambda/n' \sin \sigma'$, showing that the Airy circle radii depend on the incident wavelength, which establishes as design criteria using different areas of the area photo-sensors for different colors, or designing different lens profiles for each color.

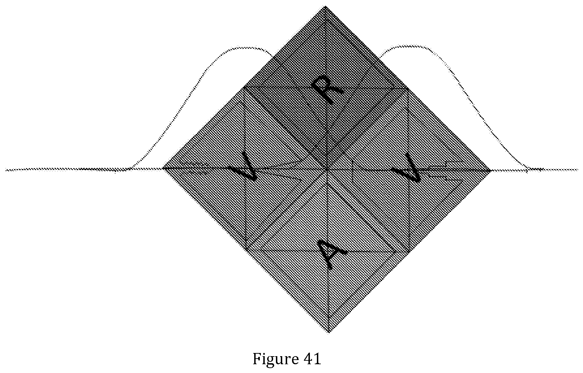

In the case of the Bayer pattern, the interference between the two adjacent green pixels in a diagonal direction is less than it would be the interference between two adjacent red pixels diagonally with the Yotsuba pattern, as the wavelength is smaller and hence the green Airy circles are smaller than red Airy circles. Still, if approaching the pixels to each other so that we reach the limit of what is prudent and the two beams of green light start to come together, we can take steps (actions) at the design of the photo-sensors, in that way Figure 41 shows how in the green pixel at the right side the gap between green pixels has widened by changing the physical structure of the photo-sensor (the left side corner of the green photo-sensor at the right has been deleted - eliminating the active area of the substrate-, turning the square into a hexagon if designing symmetrical pixels). More efficient is the green pixel on the left side of the image, a triangular area on the right side of the green photo-sensor is taken away from the right corner (making it a non-active area of the substrate), increasing farther the distance between the two adjacent green photo-sensors at the area of maximum penetration of green light from the micro-lens / filters of the adjacent green sensor, remember that light comes from the top of the structure is diffracted by the micro-lenses and finally filtered by color filters before reaching the sensor, which can be part of the same material of the microlenses or be flat color layers located below the microlenses. In either of the two situations described, the highest irradiance between two adjacent green areas of the passes will be passing through the vertex where the 3 color sensors converge (the 4 adjacent pixels) due to two reasons, firstly while going away from the vertex distance is increased and therefore the attenuation (going away from the center of the Airy disk), secondly the green light from an adjacent green pixel micro-lens that reaches areas away from the vertex passes through red and blue filters before reaching the adjacent green pixel (in areas in green-red and blue-green confluences), fading to an extent that makes it imperceptible in the adjacent green area, and this is the reason why truncating the sensor by removing a triangular zone of the area of the sensor, creating a very wide "non-sensitive" area in the zone nearer the adjacent sensor, but a zone that narrows as the distance from the adjacent sensor increases, and reaches its maximum not sensitive area in the zone of maximum penetration of green light from the adjacent diagonal sensor, light which has penetrated through the lowest attenuation point (the vertex of confluence of the four pixels, see Figure 41), minimizing the noise between pixels.

Some microelectronic technologies do not allow in their design-rules photo-lithography lines drawn at any angle, only vertical, horizontal and 45-degree angles, in which case the triangle of the sensor without photo-active area will be drawn as indicated in Figure 41 at the left side of the left-most green photo-sensor of the Bayer pattern. Other technologies are even more restrictive and allow only vertical and horizontal lines, in which case the "triangle" without active area would be designed as shown in the corner to the right-side of the green sensor at the right side of Figure 41.

The patterns presented in Figure 41 seem very small, but we must remember that the wavelengths of the light spectrum can range from about 400 nanometers at the top of the blue spectrum to about 800 nanometers in the lower spectrum Red. While at the time of writing the present patent application 28 nanometers sub-micron CMOS technology were in production in high volume, indicating that with almost any CMOS technology (or other past, present and future technologies) is easy to design geometries with dimensions much smaller than the wavelengths of the visible light spectrum, which are fixing the minimum dimensions of the microlenses and micro-sensors to avoid diffraction phenomena.

The invention described herein yield great advantages in the manufacture of large volumes of plenoptic sensors of very high quality at very low prices, also yield great advantages in terms of manufacturing sensors with an increasing number of megapixels in applications I demanding small size, allowing to reach limits in which wave phenomena of light cannot be ignored any longer, some of which are described in detail below.

Structures as described herein may also be part of 3D chips, where the bottom side of structures as shown in Figures 14, 14.b, 22.B and 22.C, instead of being soldered on a printed circuit board are located on another integrated circuit with a specific function, such as plenoptic processing.

The mentioned invention can be combined with micro-mechanical zooms, in which one (or several) of the lens(es) of the optical sandwich move(s) perpendicularly to the axial axis driven by MEMS (Micro-Electro-Mechanical Systems), and can thus refocus the image or use the structure as an optical zoom.

The mentioned invention can be combined with externally controllable static zooms, in which one (or several) of the lenses of the optical sandwich changes the focal distance(s) under the control of an external parameter (a voltage, a current or other parameter) can thus refocus the image or use the structure as an optical zoom.

The main prototypes and the first products on the market use microlenses as described in the "state of the art" section, the use of photo-sensors and micro-lenses as described herein gives them application advantages as described below.

## Usage examples showing differences from the prior art

Photo-sensors using pixel geometries as described in Figure 41 can be used to capture images of a very high density of pixels in a very small space with contrast between pixels dramatically improving the state of the art, increasing the signal / noise ratio between adjacent pixels; is worth mentioning applications such as mobile phone cameras, tablets or laptops, applications with very high megapixel count and growing more and more , as well as very small sizes (sensors occupy less than 1 cm x Icm). This invention is applicable to both traditional sensors (without plenoptic microlenses) and light field sensors (with plenoptic microlenses) but is especially beneficial in this latter case, as the balance between the number of pixels per micro-lens (to discriminate more directions of arrival) and a number of increasingly high micro-lenses in order to increase the number of usable megapixels pushes to sensors with a total number of pixels well beyond the current state of the art, remaining far away from the Moore's Law limits but alleviating as far as possible the light wave phenomena leading to unwanted refractions for very small pixel dimensions.

If possible to relax the specifications in terms of number of megapixels per unit area, as shown in Figure 40, or even more in Figure 39, which also allows the use of photo-sensors technologies lowest cost (or if using dense technologies increase the number of megapixels per unit area of the sensor), you can reach a very high number of Megapixels (beyond the current state of the art) with very high luminous efficiency and a high contrast in a camera of Normal/large sizes for applications where space is not a major design criteria (for example, in a DSLR the sensor size can be several cm each side). Also for applications in portable devices (phones, tablets, laptops, ...) you can achieve very high contrast and very high image quality (with low noise) for applications where high number of megapixels is not the fundamental goal, quality that can be very high in case the pixel area contains the first full Airy circle (as described in Figure 39), under these circumstances 84% of the incident light reaches the photo- sensors, it would only be possible to appreciably increase the sensitivity and contrast of a given sensor technology multiplying by 4 the sensors' area (to include the second Airy lobe within the area of sensor). The claims carried out in this paragraph apply to traditional sensors and digital cameras, but are especially useful for plenoptic sensors in cameras, since the number of microlenses grows exponentially and thus the number of pixels specified for discriminating a large number of directions.

The mentioned invention improve the state of the art in terms of density of pixels to the point that the dominant factor that starts to deteriorate the efficiency of the sensor/camera is the diffraction of light, especially in the red colors of longer wavelength, hence the first to experience diffraction. This can be used in normal or in plenoptics sensorsas in the applications described below.

The embodiments as set forth in Figures 14, 14.B, 15, 16, 17, 18, 22, 22.B, 22.C, 23 and 26 can result in plenoptics sensors in which, with an appropriate process of the information of the pixels you can get information not only of the intensity of color in the pixels, but also of the direction of arrival of the light rays, leading to new applications in which it is possible to re-focus images in a plane of the real world different to the plane focused during the photography shot, is possible to obtain completely focused images (at all points of the picture), to obtain 3D images (three-dimensional) for 3D displays on movie screens or in monitors with active glasses (with stereoscopic images), in screens/monitors with passive glasses or in new and future 3D screens/displays without glasses. The number of pixels and the number of possible planes focused at different depths (which increases linearly with the number of pixels per micro-lens) increases dramatically thanks to the use of the invention.

Plenoptic sensors as described can be used in small portable cameras with a number of photo-sensors relatively small, even in professional cameras with sophisticated optics and a high number of pixels. The main advantages over other plenoptic techniques that integrate plenoptic microlenses at discrete level in the lenses of the camera or as an array of microlenses discreetly located in a plane in front of the plane of the sensor, is the capability of wafer processes using manufacturing techniques similar to those used in microelectronics also for optics, obtaining plenoptic sensors of very high-quality at very low costs and with manufacturing processes that lend themselves to very high volume productions, while reducing optical aberrations and increasing the number of microlenses per unit area and the total number of pixels.

One of the drawbacks of plenoptic technologies is the resulting number of pixels, depending on the algorithms used and the possible techniques of super-resolution and interpolation of intermediate pixels in the final image (post-processed plenoptic algorithms) will result a number of pixels in the image lower than the number of pixels of the sensor; at the low end some algorithms offer a number of pixels equal to the number of plenoptic microlenses. This fact, coupled with the fact that to discriminate directions of arrival of rays requires a number of pixels per plenoptic microlens as high as possible would lead to micro-lenses and sensors beyond the state of the art.

The monolithic integration of micro-lenses using advanced micro-electronic and/or micro-optics processes, that for example in CMOS techniques have reached very high sophistication due to the large investments made for microprocessors, memories and other logic circuits, allows to have very sophisticated means of design and production that are also applicable to the plenoptic microlenses, allowing the manufacture of plenoptic micro-lens arrays with a number of lenses beyond the state of the art and with lower optical aberrations than in their equivalent discrete implementations.

To appreciate the advantages of the invention of the present application we discuss specifications for future image acquisition technologies today impossible to implement. Suppose you intend to manufacture a 3D HDTV video camera (application where today two cameras are used in parallel to produce stereoscopic images, more than doubling the cost of manufacturing, dramatically increasing costs and decreasing image quality during the post-processes) in principle there would be two possibilities, try using a micro-lens array with 1280x720 lenses (921,600 microlenses) or 640x360 lenses (211,260 micro-lenses) with an associated super-resolution algorithm to raise the final number to 1280x720 pixels. Suppose a reasonable number of 16 pixels by plenoptic microlens is used (leading to 7 focus planes), this would lead to a sensor of 14,745,600 pixels in the first case or 3,686,400 pixels when using super- resolution, especially the first value is extremely high, toward the edge of the state of the art at the time of writing this patent. In case of trying to increase the quality of 3D images and pursue 21 focused plans, would need sensors of 111.5 megapixel without using super-resolution or 25.6 Megapixels using uper-resolution 2 to 1, clearly beyond the state art at the moment to write the patent, especially for consumer applications of very low cost.

One of the first industrial plenoptic sensors announced that will be available in volume during the second quarter of 2014, is publicized on the attached link (http://lightfield-forum.com/light-field-camera-prototypes/toshiba-lightfield-camera-module/), contains an array of 500,000 microlenses of 30 microns in diameter (a number between the two values required for the HDTV camera cited in the above example) and a 8 Mega-ray CMOS image sensor (also located between the two requirements above) in an area of 7 x 5 mm. Although there are no published data on the technology, its implementation may have been carried out using similar techniques to those shown in figures 6.A, 6.B or 8.A, 8.B. According to the same web link mentioned above, the discrete implementation of figure 6.B has a number of microlenses 5 times lower than the plenoptic sensor referred to in our example, a relatively low number as compared to the invention.

From the discussion in the preceding paragraphs it follows that the state of the art could only implement an HDTV camera thanks to the use of super-resolution algorithms, always with a lower quality than algorithms without super-resolution using a higher number of micro -lenses. The microelectronic processes described in the present invention including photolithography processes, are capable of producing a number of microlenses much higher than the maximum of 500,000 microlenses announced in the previous web, besides, the fact that in their documentation they mention about the "radio" of the microlenses makes us think that they are circular rather than square lenses, always less efficient, as the area between several circles wastes some of the pixels of the photo-sensor, and also wastes part of the incident light energy.

If the design criteria was a sensor for a camera for 3D films in order to obtain 4000 x 3000 pixels, it could be designed again with 12 Mega-lenses in the plenoptic microlens array (and a 192 mega-pixel sensor assuming 16 pixels per micro-lens, focused only 7 planes) or 2000 x 1500 (3 mega-lens) in the plenoptic array (48 mega-pixel sensor) and a super-resolution factor of 2x2; both specifications (especially the first) are well beyond the state of the art, and can be implemented only thanks to the use of micro-electronic techniques such as those described herein, both for the plenoptic microlenses and for the the sensors with such high integration density exhibiting adequate levels of inter-pixel noise. If you also want to have more than 7 planes focused in order to increase the quality of the 3D image, specifications far exceed the wildest dreams about the state of the art.

Finally, the use of meta-materials with indices of refraction below 1 together with the microelectronic processes described in this patent enable the monolithic integration of a complete objective built over the sensor substrate; monolithic integrations as described in Figure 22.B (with or without lenses plenoptic 5) will result in modules with considerably lower manufacturing costs of production than as offered today in implementations as described in Figure 11, with automated production techniques that minimize to the maximum human intervention, reduce production costs and increase quality as well as the light and optical efficiency of cameras; and this without comparisons with cameras as set forth in the figures 5.A, 5.B, 7A, 7B and 7.C, solutions that will become obsolete versus the use of sensors set forth herein.

## DESCRIPTION OF FIGURES

Figure 1. Description of a possible implementations of the prior art for a plenoptic sensor.

Figure 2. Description of a second possible implementation of the prior art for a plenoptic sensor.

Figure 3. Projecting rays on a plenoptic sensor in case the plane is focused behind the sensor.

Figure 4. Projecting rays on a plenoptic sensor in case the plane is focused in front of the sensor.

Figure 5.A. Implementation of plenoptic lenses in which the microlenses are located between the main lens and the object space.

Figure 5.B. Plenoptic lenses of figure 5.A mounted between the object space (at the left of the image) and the main lens of a camera (right side of the image).

Figure 6.A. Implementation of an array of plenoptic microlenses located at a very small distance (0.5 mm) from the plane of the photo-sensors.

Figure 6.B. An early industrial implementation of the invention of Figure 6.A (an array of plenoptic microlenses located at a very small distance from the plane of the photo-sensors).

Figure 7.A. Optical schematic of an implementation in which the plenoptic microlenses are part of a lens (lens group), placed between the first input objective lens (left) and the other lenses (right).

Figure 7.B. Mechanical optical scheme of the pieces for the implementation of the structure of Figure 7.A.

Figure 7.C. Mechanical optical scheme of an implementation of the structure of Figure 7 A.

Figure 8.A. Implementation where the plenoptic microlenses are placed over a photo-sensors substrate (constructed over a transparent substrate 14b at a very small distance from the photo-sensors thanks to the use of resin separators 42 between the photo-sensors and the substrate where the microlenses are placed).

Figure 8.B. Similar to Figure 8.A where the microlenses are placed on top of the transparent substrate implementation.

Figure 8.C. Implementing a monolithic structure which places an array of microlenses 10 over a sensor array constructed on a substrate 100 with photo-sensors 30.

Figure 9.A. State of the art of a substrate using FSI (Front Side Illumination) photo-sensors technology.

Figure 9.B. State of the art of a substrate using BSI (Back Side Illumination) photo-sensors technology.

Figure 10.A. State of the art building color filters and micro-lenses on a substrate with pixel photo-sensors.

Figure 10.B. Evolution of the state of the art building color filters and micro-lenses on a substrate pixel photo-sensors beyond Figure 10.A.

Figure 10.c. Top view of Figure 10.B.

Figure 11. Camera Module for portable applications (mobile phone, tablet, laptop), comprising photo-sensor (mounted on a flexible printed circuit) and a mechanical support for placing the lenses on the photo-sensor.

Figure 12. Camera Module for portable applications (mobile phone, tablet, laptop), comprising photo-sensor (mounted over a flexible printed circuit board) and a lens (126) of two elements on a transparent substrate, all wrapped in an opaque conductive pattern which protects electromagnetic radiation and provides mechanical strength to the assembly.

Figure 13. Camera module for portable applications (mobile phone, tablet, laptop), similar to Figure 12 but two lens elements on two transparent substrates, and a third transparent substrate to protect the structure.

Figure 14. Implementation of one embodiment of the present application containing a substrate (1) with photo-sensors (2), on which color filters are located (6, 7 and 8), pixel micro-lenses (3), a low refractive index material (4) and the plenoptic microlenses (5).

Figure 14.b. Similar to the above (Figure 14) in which the material of low refractive index has been replaced by air (or other gas) and the microlenses wafer is maintained at a certain distance of the sensor wafer thanks to the use of separators.

Figure 15. Example of a second embodiment of the present application.

Figure 17. Example of a fourth embodiment of the present application.

Figure 18. Example of a fifth embodiment of the present application.

Figures 19, 20, 21, 22. Details of a sequence of manufacturing of the plenoptic microlenses over the pixel microlenses using for the optics processes normally used in microelectronics, processes that lend themselves to wafer processing to manufacture very high volumes with very high quality and very low cost.

Figure 22-b Size miniaturization thanks to the use of materials (or meta-materials) with indices of refraction less than 1 (layers 4, 4', 4", 4'" and 4""), which makes possible the implementation of a full monolithic objective including several lenses (5"" 5'", 5", 5') and the plenoptic microlenses (5).

Figure 22.C. Implementation of the invention with similar functionality as in Figure 22.B replacing the material with low refractive index by air (or other gas) and maintaining the optical wafers spaced from each other and from the optoelectronic wafer by spacers.

Figure 23. Example of an implementation similar to figure 14 where the area of the photo-sensors is relatively low as compared to the total area of the substrate of photo-sensors and therefore the plenoptic microlenses (3) have a thickness at the top substrate higher than in the implementation of figure 14.

Figure 24. Details of the construction of a micro-lens (composed of 4 spherical or aspherical sectors) over a photo-sensor and the portion of the substrate closest to said photo-sensor.

Figure 25.A. Top view of Figure 24, showing the construction of two micro-lenses on two photo sensors, including the part of the substrate nearest to said photo-sensor.

Figure 25.B. Top view of Figure 24, showing the construction of an array of 4x4 micro-lenses over 4x4 photo-sensors and the part of the substrate nearest to said photo-sensors.

Figure 26. Cross section of Figure 25B, showing the construction of a plenoptic micro-lens (5) on a material of low refractive index (4), located on the 4x4 array of pixel microlenses (3), located on a 4x4 array of color filters (8, 6, 7), in turn located on a 4x4 array of photo-sensors (2) built on a substrate (1).

Figure 27.A. Irradiance distribution associated with the image of a point object over the plane of the sensors in a system with a round exit pupil, leading to Airy discs and rings (the top of the figure shows the irradiance distribution in the vertical axis versus the horizontal axis distance from the center point of the image over the sensor, at the bottom of the figure power levels are shown through the intensity of the gray colors).

Figure 27.B. Representation (at the top of the figure) of a "quadri-circle" resulting Airy pattern using square pixel microlenses as described in Figures 24, 25 A, and 25 B, compared to what would be the Airy circle and ring (at the bottom of the figure) if the optics had a circular shape.

Figure 28. Micro-pixel lenses overlapping each other in a topology in which the percentage of photo-sensor area to the total area of the substrate is high and the thickness of the microlenses to fulfill its function imposes such overlap.

Figure 29. Lateral section of figure 28 including substrate (1), photo-sensors (2), color filters (6, 7, 8) pixel microlenses (3) low refractive index layer (4) and plenoptic micro-lens (5). Note that the layer 4 of low refractive index never actually touch the color filters (8, 6 and 7).

Figure 30. Structure in which the color filters are grouped by plenoptic microlens, and have been distributed between the layer under the pixel microlenses and over the plenoptic microlenses. They can also fulfill the mission of infrared filtering.

Figure 31. Structure in which the color filters are grouped by plenoptic microlens, providing said plenoptic microlenses with a second function, as lenses are built with a material that besides producing the required change of the refractive index is selective to the passage of colors.

Figure 32. Structure in which the color filters are grouped into the plenoptic microlenses and the pixel microlenses, providing all the microlenses (plenoptic and pixel) a second function, as they are built with a material that besides producing the required refractive index change is selective to the passage of colors.

Figure 33.A. Irradiance distributions associated with images of two adjacent point objects in the object space projected onto two adjacent pixels in the sensor plane through two adjacent microlenses, resulting in two non-overlapping Airy disks and two interfering rings Airy in an area between pixels.

Figure 33.B. Irradiance distributions associated with four contiguous images of four point objects in the object space, projected onto four adjacent pixels in the plane of sensors across four adjacent microlenses. The pixels are reduced to their minimum acceptable dimensions in order to avoid diffractions caused by wave nature of light; in order to increase the pixel density, the peak (maximum) of Airy disks are located on the zeros of irradiance of adjacent pixels.

Figure 34. irradiance distributions over a Bayer pattern on a green pixel and a red pixel (on the blue would be similar) where the microlenses, the areas of the photo-sensors and the opaque areas between photo-sensors, have been dimensioned so that the main lobe (the Airy circle) is fully contained within the area of the photo-sensor, and the second and third lobes (second and third Airy rings) fall over an opaque area without photo-sensors.

Figure 35. Cross section of Figure 34, showing (from the bottom to the top) the photo-sensors substrate (1), the photosensor (2), the green (6) and red (7) color filters and the pixel microlenses (3). Color filters in the area of the substrate where no photo-sensors are located lie over a metal layer (used for polarization and/or reading) or other opaque material. The magnitude of the irradiance is shown: the two green and red Airy circles are contained entirely in the area of the photo-sensors.

Figure 36. Yotsuba pattern, more sensitive to inter-pixel noise than the Bayer pattern, as there are more pixels of the same color diagonally interfering each other.

Figure 37. In order to increase the density of pixels per unit area it has been accepted that the second and third lobes of irradiance may interfere the neighbor pixel.

Figure 38. In order to further increase the density of pixels per unit area has even accepted that the Airy peaks are located at the zeros of neighboring pixels, accepting that not all the energy of the main lobe will be used by the sensors, interference between pixels of different colors is minimized by filtering colors.

Figure 39. The most critical in terms of inter-pixel noise pixels are the same color (green in a Bayer pattern) and diagonally adjacent, as its interference cannot be filtered.

Figure 40. The distance between adjacent pixels of the same color will be fixed by the maximum acceptable signal to noise ratio for the application, which will deteriorate drastically as the first Airy lobe of a pixel starts interfering with the first Airy lobe of the adjacent pixel of the same color (both green in a Bayer pattern).

Figure 41. The distance between adjacent pixels of the same color will be fixed by the maximum acceptable signal to noise ratio for the application, which will deteriorate drastically as the first Airy lobe of a pixel start interfering with the first Airy lobe of the adjacent pixel of the same color (both green in a Bayer pattern), which can be minimized by special geometries for the photo-sensors of adjacent pixels of the same color, in which the vertices of the squares of the photo-sensors are built further away by not building photo sensor active area in the zones near the neighboring pixel of the same color.

## References.

1. V. G. Veselago (1968 (Russian text 1967)).. Sov. Phys. Usp. 10 (4): 509-14. Bibcode: 1968SvPhU.10.509V. doi: 10.1070 / PU 1968v010n04ABEH003699

2. Negative Refraction at Visible Frequencies, Henry J. Lezec et al., Science 316, 430 (2007); DOI: 10.1126/science.II39266.

## Claims

1. Plenoptic sensor that integrates monolithically the following elements:

   a substrate (1) with a plurality of photo-sensors (2) built on the substrate (1);
   a plurality of layers (4,4',4",4"',4"") of one or more materials of low refractive index, said low refractive index layers (4,4',4",4"',4"") positioned above said substrate (1) and said plurality of photo-sensors;
   a plurality of plenoptic micro-lenses (5) constructed with a material of high refractive index and located above one of the low refractive index layers (4,4',4",4''',4'''');

a plurality of lenses (5',5",5''',5'''') constructed with a material of high refractive index and located above said plenoptic micro-lenses (5) and above one of the low refractive index layers (4,4',4",4''',4""), wherein the shape of the lenses is selected among the following: biconvex, biconcave, concave-convex, convex-concave, plano-concave, plano-convex, concave-flat, concave meniscus structure and convex meniscus structure;

**characterised in that** low refractive index layers (4,4',4",4") are successively added forming spaces of low refractive index between different plenoptic micro-lenses (5) and lenses (5',5",5''',5"") and the plurality of lenses (5',5",5''',5"") and low refractive index layers (4,4',4",4''') are alternately stacked on top of one another.

2. Plenoptic sensor as described in claim 1, wherein the materials of the several refractive indexes are built on a CMOS or a CCD photo-sensor.

3. Plenoptic sensor as described in any of claims 1 to 2, comprising a plurality of pixel micro-lenses (3), wherein each pixel micro-lens (3) is located above a photo-sensor (2) and below the plurality of low refractive index layers (4,4',4",4''',4""), wherein each pixel micro-lens (3) has a refractive index higher than the low refractive index layer (4,4',4",4''',4"") and focuses a beam of light into the inner part of the photo-sensor (2).

4. Plenoptic sensor as described in claims 1 to 3, wherein color filters are added, either on each photo-sensor, or on each plenoptic microlens, or below plenoptic microlenses or built in colored materials constituting the plenoptic microlenses or built in colored materials constituting the pixel microlenses, or either based on combinations of the above.

5. Plenoptic sensor as set forth in claims 1 to 4, further comprising near infrared or infrared filters, wherein the infrared filters are constructed as part of the materials of the color filters.

6. Plenoptic sensor as set forth in claims 1 to 4, wherein filters that prevent the passage of visible light are added, allowing only infrared spectrum.

7. Plenoptic sensor as described in claims 1 to 6, wherein the material of low refractive index referred is a meta material or a material with a refractive index lower than one, thereby reducing the distance between high refractive index lenses and the sensor.

8. Plenoptic sensor as described in claims 1 to 7, wherein the plenoptic microlenses are designed forming a plenoptic array with gradually more asymmetric profiles as are placed at greater distances from the center of the plenoptic array in order to improve efficiency in the most remote areas far away from the center of the array of photo-sensors.

9. Plenoptic sensor as described in claims 1 to 8, wherein the plenoptic microlenses are designed forming a plenoptic array having distances to the substrate or to the pixel microlenses gradually smaller as the plenoptic microlenses are located at greater distances from the center of the plenoptic array , thereby improving efficiency in the areas away from the center of the array of photo-sensors, wherein all the microlenses are constructed steeper as they are located away from the center of the plenoptic array, wherein the microlenses at the center of the array are perpendicular, or quasi-perpendicular to the optical axis.

10. Plenoptic sensor as described in claims 1 to 9, wherein the distances between photo-sensors are different at the center and at the periphery of the array of photo-sensors, gradually changing from the center to the periphery thereby improving efficiency in the most outlying areas of the array of photo-sensors.

11. Plenoptic sensor as described in claims 1 to 10, wherein on one or more of the optical layers and/or one or more of the lenses has one or more deposited layers of anti-reflective coating.

12. A method of manufacturing of the plenoptic sensor of any of claims 1 to 11, comprising constructing the optical layers on the substrate using manufacturing techniques used for semiconductor processing: processing for wafers, deposition of various layers of material, using at least one of the following techniques: CVD, LPCVD, PECVD, HIPCVD , optical sandwich stacking wafers and / or using separators, photolithography, using photo-resistive material , chemical attack with solvents, plasma attacks, doped optical and electronic materials, heat treatments, ultraviolet or thermal curing, packaging circuit with a plurality of encapsulations.

13. An arrangement comprising:
a plurality of plenoptic sensors according to claims 1 to 11 further incorporating:

micro-mechanic zooms, in a number of optical lenses of the sandwich; or
static zooms in a number of the lenses of the optical sandwich that change the focal distance(s) under the control of an external parameter, the external parameter being a voltage, a current or other parameter; or

a combination of micro-mechanical zooms and static zooms controllable by external parameters.

**Patentansprüche**

1. Plenoptischer Sensor, der die folgenden Elemente monolithisch integriert:

ein Substrat (1) mit einer Vielzahl von auf dem Substrat (1) gebauten Fotosensoren (2); eine Vielzahl von Schichten (4, 4', 4", 4'", 4"") aus einem oder mehreren Materialien mit niedrigem Brechungsindex, wobei die Schichten (4, 4', 4", 4'", 4"") mit niedrigem Brechungsindex über dem Substrat (1) und der Vielzahl von Fotosensoren positioniert sind; eine Vielzahl von plenoptischen Mikrolinsen (5), die aus einem Material mit hohem Brechungsindex gebildet sind und sich über einer der Schichten (4, 4', 4", 4'", 4"") mit niedrigem Brechungsindex befinden;eine Vielzahl von Linsen (5', 5", 5'", 5""), die aus einem Material mit hohem Brechungsindex gebildet sind und sich über den plenoptischen Mikrolinsen (5) und über einer der Schichten (4, 4', 4", 4'", 4"") mit niedrigem Brechungsindex befinden, wobei die Form der Linsen unter den folgenden ausgewählt ist: bikonvex, bikonkav, konkav-konvex, konvex-konkav, plankonkav, plankonvex, konkav-flach, konkave Meniskusstruktur und konvexe Meniskusstruktur; **dadurch gekennzeichnet, dass** Schichten (4, 4', 4", 4'", 4"") mit niedrigem Brechungsindex nacheinander unter Bildung von Zwischenräumen mit niedrigem Brechungsindex zwischen verschiedenen plenoptischen Mikrolinsen (5) und Linsen (5', 5", 5'", 5"") hinzugefügt werden, wobei die Vielzahl von Linsen 5', 5", 5'", 5"") und Schichten (4, 4', 4") mit niedrigem Brechungsindex abwechselnd übereinander gestapelt sind.

2. Plenoptischer Sensor nach Anspruch 1, wobei die Materialien der verschiedenen Brechungsindizes auf einem CMOS- oder einem CCD-Fotosensor gebauten sind.

3. Plenoptischer Sensor, nach einem der Ansprüche 1 bis 2, umfassend eine Vielzahl von Pixel-Mikrolinsen (3), wobei sich jede Pixel-Mikrolinse (3) über einem Fotosensor (2) und unter der Vielzahl von Schichten mit niedrigem Brechungsindex (4, 4', 4", 4'", 4"") befindet, wobei jede Pixel-Mikrolinse (3) einen höheren Brechungsindex als die Schicht mit niedrigem Brechungsindex (4, 4', 4", 4'", 4"") aufweist und einen Lichtstrahl in den inneren Teil des Fotosensors (2) fokussiert.

4. Plenoptischer Sensor nach Anspruch 1 bis 3, wobei entweder auf jedem Fotosensor oder auf jeder plenoptischen Mikrolinse oder unter plenoptischen Mikrolinsen oder eingebauten farbigen Materialien, die die plenoptischen Mikrolinsen bilden, oder eingebauten farbigen Materialien, die die Pixel-Mikrolinsen bilden, oder entweder basierend auf Kombinationen der oben genannten Farbfilter hinzugefügt werden.

5. Plenoptischer Sensor nach Anspruch 1 bis 4, ferner umfassend Nahinfrarot- oder Infrarotfilter, wobei die Infrarotfilter als Teil der Materialien der Farbfilter konstruiert sind.

6. Plenoptischer Sensor nach Anspruch 1 bis 4, wobei Filter hinzugefügt werden, die den Durchgang von sichtbarem Licht verhindern und nur Infrarotspektrum zulassen.

7. Plenoptischer Sensor nach Anspruch 1 bis 6, wobei das Material mit niedrigem Brechungsindex ein Metamaterial oder ein Material mit einem Brechungsindex von weniger als eins ist, wodurch der Abstand zwischen Linsen mit hohem Brechungsindex und dem Sensor verringert wird.

8. Plenoptischer Sensor nach Anspruch 1 bis 7, wobei die plenoptischen Mikrolinsen so ausgelegt sind, dass sie einen plenoptischen Array mit allmählich asymmetrischeren Profilen bilden, die in größeren Abständen von der Mitte des plenoptischen Arrays angeordnet sind, um die Effizienz in den entferntesten Bereichen zu verbessern, die weit von der Mitte des Arrays der Fotosensoren entfernt sind.

9. Plenoptischer Sensor nach Anspruch 1 bis 8, wobei die plenoptischen Mikrolinsen so ausgelegt sind, dass sie einen plenoptische Array bilden, deren Abstände zum Substrat oder zu den Pixel-Mikrolinsen allmählich kleiner werden, wenn sich die plenoptischen Mikrolinsen in größeren Abständen von der Mitte des plenoptischen Arrays befinden, sodass die Effizienz in den Bereichen entfernt von der Mitte des Arrays von Fotosensoren verbessert wird, wobei alle Mikrolinsen steiler konstruiert sind, wenn sie sich entfernt von der Mitte des plenoptischen Arrays befinden, wobei die Mikrolinsen in der Mitte des Arrays senkrecht oder quasi senkrecht zur optischen Achse sind.

10. Plenoptischer Sensor nach Anspruch 1 bis 9, wobei die Abstände zwischen Fotosensoren in der Mitte und am Umfang des Arrays von Fotosensoren unterschiedlich sind und sich allmählich von der Mitte zur Peripherie ändern, wodurch die Effizienz in den äußersten Bereichen des Arrays von Fotosensoren verbessert wird.

11. Plenoptischer Sensor nach Anspruch 1 bis 10, wobei auf einer oder mehreren der optischen Schichten und/oder einer oder mehreren der Linsen eine oder mehrere Schichten einer Antireflexbeschichtung aufgebracht sind.

12. Verfahren zur Herstellung des plenoptischen Sensors nach einem der Ansprüche 1 bis 11, umfassend das Konstruieren der optischen Schichten auf dem Substrat unter Verwendung von Herstellungstechniken, die für die Halbleiterverarbeitung verwendet werden: Verarbeitung für Wafer, Abscheidung verschiedener Materialschichten unter Verwendung mindestens einer der folgenden Techniken: CVD, LPCVD, PECVD, HIPCVD, optische Sandwich-Stapelwafer und/oder unter Verwendung von Separatoren, Photolithographie, unter Verwendung von photoresistivem Material, chemischem Angriff mit Lösungsmitteln, Plasmaangriffen, dotierten optischen und elektronischen Materialien, Wärmebehandlungen, ultravioletter oder thermischer Härtung, Verpackungsschaltung mit einer Vielzahl von Einkapselungen.

13. Anordnung, umfassend:
eine Vielzahl von plenoptischen Sensoren nach Anspruch 1 bis 11, die ferner aufnehmen:
mikromechanische Zooms in einer Anzahl von optischen Linsen des Sandwichs; oder statische Zooms in einer Anzahl von Linsen des optischen Sandwichs, welche die Brennweite(n) unter der Steuerung eines externen Parameters ändern, wobei der externe Parameter eine Spannung, ein Strom oder ein anderer Parameter ist; oder eine Kombination aus mikromechanischen Zooms und statischen Zooms, die durch externe Parameter gesteuert werden können.

**Revendications**

1. Capteur plénoptique qui intègre de manière monolithique les éléments suivants :

un substrat (1) avec une pluralité de photocapteurs (2) bâtis sur le substrat (1) ;
une pluralité de couches (4, 4', 4", 4'", 4"") d'un ou plusieurs matériaux à faible indice de réfraction, lesdites couches à faible indice de réfraction (4, 4', 4", 4'", 4"") positionnées au-dessus dudit substrat (1) et de ladite pluralité de photocapteurs ;
une pluralité de microlentilles plénoptiques (5) construites avec un matériau à indice de réfraction élevé et situées au-dessus de l'une des couches à faible indice de réfraction (4, 4', 4", 4'", 4"") ;
une pluralité de lentilles (5', 5", 5'", 5"") construites avec un matériau à indice de réfraction élevé et situées au-dessus desdites microlentilles plénoptiques (5) et au-dessus de l'une des couches à faible indice de réfraction (4, 4', 4", 4'", 4"") dans lequel la forme des lentilles est choisie parmi les suivantes : biconvexe, biconcave, concavo-convexe, convexo-concave, plan-concave, plan-convexe, concave-plat, structure du ménisque concave et structure de ménisque convexe ;
**caractérisé en ce que**
des couches à faible indice de réfraction (4, 4', 4", 4") sont successivement ajoutées formant des espaces de faible indice de réfraction entre les différentes microlentilles plénoptiques (5) et les lentilles (5', 5", 5'", 5"") et la pluralité de lentilles (5', 5", 5'", 5"") et les couches à faible indice de réfraction (4, 4', 4", 4"") sont alternativement empilées les unes sur les autres.

2. Capteur plénoptique tel que décrit dans la revendication 1, dans lequel les matériaux des divers indices de réfraction sont bâtis sur un capteur CMOS ou CCD.

3. Capteur plénoptique tel que décrit dans l'une quelconque des revendications 1 à 2, comprenant une pluralité de microlentilles de pixel (3), dans lequel chaque microlentille de pixel (3) est située au-dessus d'un photocapteur (2) et en dessous de la pluralité de couches à faible indice de réfraction (4, 4', 4", 4'", 4""), dans lequel chaque microlentille de pixel (3) a un indice de réfraction supérieur à la couche à faible indice de réfraction (4, 4', 4", 4'", 4"") et focalise un faisceau de lumière dans la partie interne du photocapteur (2).

4. Capteur plénoptique tel que revendiqué dans les revendications 1 à 3, dans lequel des filtres couleur sont ajoutés, soit sur chaque photocapteur, soit sur chaque microlentille plénoptique, soit en dessous des microlentilles plénoptiques soit bâtis dans des matériaux colorés constituant les microlentilles plénoptiques soit bâtis dans des matériaux colorés constituant les microlentilles de pixels, ou soit sur la base des combinaisons de ce qui précède.

5. Capteur plénoptique selon les revendications 1 à 4, comprenant en outre des filtres proche infrarouge ou infrarouge, dans lequel les filtres infrarouges sont construits en tant que partie des matériaux des filtres colorés.

**6.** Capteur plénoptique selon les revendications 1 à 4, dans lequel sont ajoutés des filtres qui empêchent le passage de la lumière visible, n'autorisant que le spectre infrarouge.

**7.** Capteur plénoptique tel que revendiqué dans les revendications 1 à 6, dans lequel le matériau à faible indice de réfraction mentionné est un métamatériau ou un matériau avec un indice de réfraction inférieur à un, réduisant ainsi la distance entre les lentilles à indice de réfraction élevé et le capteur.

**8.** Capteur plénoptique tel que revendiqué dans les revendications 1 à 7, dans lequel les microlentilles plénoptiques sont conçues en formant un réseau plénoptique avec des profils progressivement plus asymétriques comme elles sont placées à de plus grandes distances du centre du réseau plénoptique afin d'améliorer l'efficacité dans les zones les plus éloignées à l'écart du centre du réseau de photocapteurs.

**9.** Capteur plénoptique tel que revendiqué dans les revendications 1 à 8, dans lequel les microlentilles plénoptiques sont conçues en formant un réseau plénoptique ayant des distances par rapport au substrat ou aux microlentilles de pixel graduellement plus petites comme les microlentilles plénoptiques sont situées à des distances plus grandes du centre du réseau plénoptique, améliorant ainsi l'efficacité dans les zones à l'écart du centre du réseau de photocapteurs, dans lequel toutes les microlentilles sont construites plus raides comme elles sont situées à l'écart du centre du réseau plénoptique, dans lequel les microlentilles au centre du réseau sont perpendiculaires, ou quasi-perpendiculaires à l'axe optique.

**10.** Capteur plénoptique tel que revendiqué dans les revendications 1 à 9, dans lequel les distances entre les photocapteurs sont différentes au centre et à la périphérie du réseau de photocapteurs, en changeant progressivement du centre à la périphérie, améliorant ainsi l'efficacité dans les zones les plus excentrées du réseau de photocapteurs.

**11.** Capteur plénoptique tel que revendiqué dans les revendications 1 à 10, dans lequel sur l'une ou plusieurs des couches optiques et/ou l'une ou plusieurs des lentilles il y a une ou plusieurs couches déposées de revêtement antireflet.

**12.** Procédé de fabrication du capteur plénoptique selon l'une quelconque des revendications 1 à 11, comprenant la construction des couches optiques sur le substrat en utilisant des techniques de fabrication utilisées pour le traitement de semiconducteurs : le traitement des plaquettes, le dépôt de diverses couches de matériau, en utilisant au moins l'une des techniques suivantes : CVD, LPCVD, PECVD, HIPCVD, des plaquettes d'empilage en sandwich optique et/ou utilisant des séparateurs, la photolithographie, en utilisant un matériau photorésistif, l'attaque chimique avec des solvants, les attaques au plasma, les matériaux optiques et électroniques dopés, les traitements thermiques, le durcissement aux ultraviolets ou thermique, le circuit de conditionnement avec une pluralité d'encapsulations.

**13.** Agencement comprenant :
une pluralité de capteurs plénoptiques selon les revendications 1 à 11 incorporant en outre :

des zooms micromécaniques, dans un certain nombre de lentilles optiques du sandwich ; ou des zooms statiques dans un certain nombre des lentilles du sandwich optique qui modifient la(les) distance(s) focale(s) sous le contrôle d'un paramètre externe, le paramètre externe étant une tension, un paramètre courant ou autre ; ou une combinaison de zooms micromécaniques et de zooms statiques contrôlables par des paramètres externes.

Figure 1

Figure 2

Figure 3

Figure 4

Figure 5.A

Figure 5.B

Figure 6.A

Figure 6.B

Figure 7.A

Figure 7.B

Figure 7.C

Figure 8.A

Figure 8.B

Figure 8.C

Figure 9.A                Figure 9.B

| R | G | B |
|---|---|---|

| R | G | B |
|---|---|---|

Figure 10.A          Figure 10.B          Figure 10.C

Figure 11

Figure 12

Figure 13

Figure 14

Figure 14.b

Índice de refracción 3 o índice de refracción 1

Índice de Refracción 2

Índice de Refracción 1

Figure 15

Índice de Refracción 4

Índice de Refracción 3

Índice de Refracción 2

Índice de Refracción 1

Figure 16

Índice de Refracción 2

Índice de Refracción 1

Figure 17

Índice de Refracción 2

Índice de Refracción 1

Figure 18

Indice de Refracción 2

x

Indice de Refracción 1

Figure 19

Etching o ataque fotolitográfico

x

Indice de Refracción 2

Indice de Refracción 1

Figure 20

Indice de Refracción 3 o índice de refracción 1

x

Indice de Refracción 2

Indice de Refracción 1

Figure 21

Etching o ataque fotolitográfico

Indice de refracción 3 o indice de refracción 1

Indice de refracción 2

x

Indice de refracción 1

Figure 22

Figure 22.B

Figure 22.C

Figure 23

Figure 24

Figure 25.A

Figure 25.B

Figure 26

Figure 27.A

Figure 27.B

Figure 28

Figure 29

Figure 30

Indice Refracción-3 Verde    Indice Refracción-3 Rojo    Indice Refracción-3 Azul

x

Indice de refracción 2

Indice de refracción 1

Figure 31

Indice Refracción-3 Verde    Indice Refracción-3 Rojo    Indice Refracción-3 Azul

x

Indice de refracción 2

Indice Refracción-1 Verde    Indice Refracción-1 Rojo    Indice Refracción-1 Azul

Figure 32

Figure 33.A

Figure 33.B

Figure 34

Figure 35

Figure 36

Figure 37

Figure 38

**Figura 39**

Figure 39

Figure 40

Figure 41

## REFERENCES CITED IN THE DESCRIPTION

**Patent documents cited in the description**

- US 8290358 B1
- US 20130033636 A
- GB 2488905 A
- US 2007025074 A
- US 20120300097 A
- US 20090041448 A
- US 20100020187 A
- US 20110169994 A

- US 20120218448 A
- US 20120050589 A
- US 20110228142 A1
- US 20120012959 A1
- US 20120012959 A
- US 20090134483 A1
- US 2011292271 A1
- WO 2004027880 A2

**Non-patent literature cited in the description**

- **A. LUMSDAINE ; T.GEORGIEV.** Full resolution Lightfield rendering. *Technical report, Adobe Systems,* January 2008

- **V. G. VESELAGO.** *Sov. Phys. Usp.,* 1968, vol. 10 (4), 509-14
- **HENRY J. LEZEC et al.** Negative Refraction at Visible Frequencies. *Science,* 2007, vol. 316, 430